(19) Europäisches Patentamt
European Patent Office
Office européen des brevets

(11) EP 2 497 083 B1

(12) EUROPÄISCHE PATENTSCHRIFT

(45) Veröffentlichungstag und Bekanntmachung des Hinweises auf die Patenterteilung:
**25.12.2013 Patentblatt 2013/52**

(21) Anmeldenummer: **10773075.6**

(22) Anmeldetag: **02.11.2010**

(51) Int Cl.:
***G11B 7/245*** (2006.01) ***C08G 18/28*** (2006.01)
***G03F 7/027*** (2006.01) ***G03H 1/00*** (2006.01)
***G11B 7/24*** (2013.01)

(86) Internationale Anmeldenummer:
**PCT/EP2010/066594**

(87) Internationale Veröffentlichungsnummer:
**WO 2011/054797 (12.05.2011 Gazette 2011/19)**

# (54) PHOTOPOLYMER-FORMULIERUNG MIT VERSCHIEDENEN SCHREIBCOMONOMEREN

Photopolymer formulation with various comonomers

Formule de photopolymères dotée de co-monomères d'écriture différents

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **03.11.2009 EP 09013769**

(43) Veröffentlichungstag der Anmeldung:
**12.09.2012 Patentblatt 2012/37**

(73) Patentinhaber: **Bayer Intellectual Property GmbH**
**40789 Monheim (DE)**

(72) Erfinder:
- **WEISER, Marc-Stephan**
  **51379 Leverkusen (DE)**
- **BRUDER, Friedrich-Karl**
  **47802 Krefeld (DE)**
- **RÖLLE, Thomas**
  **51381 Leverkusen (DE)**
- **FÄCKE, Thomas**
  **51375 Leverkusen (DE)**
- **HÖNEL, Dennis**
  **53909 Zülpich-Wichterich (DE)**
- **HOFMANN, Jörg**
  **47800 Krefeld (DE)**

(74) Vertreter: **BIP Patents**
**c/o Bayer Intellectual Property GmbH**
**Creative Campus Monheim**
**Alfred-Nobel-Straße 10**
**40789 Monheim (DE)**

(56) Entgegenhaltungen:
**WO-A-2008/125201** **US-A- 5 725 970**
**US-A1- 2004 002 008** **US-A1- 2004 179 457**

- **M. L. SCHILLING ET AL.: "Acrylate Oligomer-Based Photopolymers for Optical Storage Applications", CHEMISTRY OF MATERIALS, Bd. 11, 1999, Seiten 247-254, XP002568849,**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 497 083 B1

## Beschreibung

Die Erfindung betrifft eine Photopolymer-Formulierung umfassend Matrixpolymere, Schreibmonomere und Photoinitiatoren. Weitere Gegenstände der Erfindung sind die Verwendung der Photopolymer-Formulierung zur Herstellung von optischen Elementen, insbesondere zur Herstellung von holgraphischen Elementen und Bildern, ein Verfahren zur Herstellung der Photopolymer-Formulierung sowie ein Verfahren zur Belichtung von holographischen Medien aus der Photopolymer-Formulierung.

Photopolymer-Fonnulierungen der eingangs genannten Art sind im Stand der Technik bekannt. So ist beispielsweise in der WO 2008/125229 A1 eine Photopolymer-Formulierung beschrieben, die Polyurethan-basierte Matrixpolymere, ein Schreibmonomer auf Acrylatbasis sowie Photoinitiatoren enthält. Im ausgehärtetem Zustand sind in der Polyurethanmatrix das Schreibmonomer und die Photoinitiatoren räumlich isotrop verteilt eingebettet. Aus der WO-Schrift ist ebenfalls bekannt, dass der Photopolymer-Formulierung weitere Komponenten wie z.B. Dibutylphthalat, ein klassischer Weichmacher für technische Kunststoffe, hinzugefiigt werden können.

Für die Verwendungen von Photopolymer-Formulierungen spielt die durch die holographische Belichtung im Photopolymer erzeugte Brechungsindexmodulation $\Delta n$ die entscheidende Rolle. Bei der holographischen Belichtung wird das Interferenzfeld aus Signal- und Referenzlichtstrahl (im einfachsten Fall das zweier ebenen Wellen) durch die lokale Photopolymerisation von z.B. hochbrechenden Acrylate an Orten hoher Intensität im Interferenzfeld in ein Brechungsindexgitter abgebildet. Das Brechungsindexgitter im Photopolymeren (das Hologramm) enthält alle Information des Signallichtstrahls. Durch Beleuchtung des Hologramms nur mit dem Referenzlichtstrahl kann dann das Signal wieder rekonstruiert werden. Die Stärke des so rekonstruierten Signals im Verhältnis zur Stärke des eingestrahlten Referenzlichts wird Beugungseffizienz genannt, im folgenden DE wie Diffraction Efficiency. Im einfachsten Fall eines Hologramms, das aus der Überlagerung zweier ebener Wellen entsteht ergibt sich die DE aus dem Quotienten der Intensität des bei der Rekonstruktion abgebeugten Lichtes und der Summe der Intensitäten aus eingestrahltem Referenzlicht und abgebeugtem Licht. Je höher die DE desto effizienter ist ein Hologramm in Bezug auf die Lichtmenge des Referenzlichtes die notwendig ist, um das Signal mit einer festen Helligkeit sichtbar zu machen. Hochbrechende Acrylate sind in der Lage, Brechungsindexgitter mit hoher Amplitude zwischen Bereichen mit niedrigem Brechungsindex und Bereichen mit hohem Brechungsindex zu erzeugen und damit in Photopolymer-Formulierungen Hologramme mit hohem DE und hohem $\Delta n$ zu ermöglichen. Dabei ist zu beachten, dass DE vom Produkt aus $\Delta n$ und der Photopolymerschichtdicke d abhängt. Je größer das Produkt desto größer die mögliche DE (für Reflexionshologramme). Die Breite des Winkelbereiches bei dem das Hologramm z.B. bei monochromatischer Beleuchtung sichtbar wird (rekonstruiert) hängt nur von der Schichtdicke d ab. Bei Beleuchtung des Hologramms mit z.B. weißem Licht hängt die Breite des spektralen Bereiches der zur Rekonstruktion des Hologramms beitragen kann ebenfalls nur von der Schichtdicke d ab. Dabei gilt je kleiner d desto größer die jeweiligen Akzeptanzbreiten. Will man daher helle und leicht sichtbare Hologramme herstellen, ist ein hohes $\Delta n$ und eine geringe Dicke d anzustreben und zwar so das DE möglichst groß wird. Das heißt je höher $\Delta n$ wird, desto mehr Freiraum zur Gestaltung der Schichtdicke d für helle Hologramme erreicht man ohne Verlust an DE. Daher kommt der Optimierung von $\Delta n$ bei der Optimierung von Photopolymer-Formulierungen eine herausragenden Bedeutung zu (P. Hariharan, Optical Holography, 2nd Edition, Cambridge University Press, 1996).

Aufgabe der vorliegenden Erfindung war es eine Photopolymer-Formulierung bereit zu stellen, die im Vergleich zu den bekannten Formulierungen die Herstellung von Hologrammen mit höherer Helligkeit (also höherer Brechungsindexmodulation $\Delta n$) ermöglicht.

Diese Aufgabe ist bei der erfindungsgemäßen Photopolymer-Formulierung dadurch gelöst, dass sie eine Kombination von wenigstens zwei verschiedenen Schreibmonomeren enthält. Unter "verschieden" ist dabei zu verstehen, dass sich die Schreibmonomere in ihrer chemischen Struktur und / oder in ihren physikalischen Eigenschaften unterscheiden.

Es wurde gefunden, dass die Verwendung einer Kombination von zwei verschiedenen Schreibmonomeren in den bekannten Photopolymer-Formulierungen bei den hieraus hergestellten Hologrammen zu höheren $\Delta n$-Werten führt als wenn eine äquivalente Menge nur eines Schreibmonomers eingesetzt wird. Im Ergebnis bedeutet dies, dass die aus der erfindungsgemäßen Formulierung hergestellten Hologramme eine im Vergleich zu den bekannten Hologrammen höhere Helligkeit aufweisen.

Als erfindungswesentliche Schreibcomonomere können Mischungen von Verbindungen wie $\alpha,\beta$-ungesättigte Carbonsäurederivate auf Acrylatbasis wie Acrylate, Methacrylate, Acrylamide, Acrylnitril, Methacrylnitril, Methacrylamid, Methacrylsäure, Acrylsäure eingesetzt werden. Bevorzugt sind Acrylate und Methacrylate.

Als Acrylate bzw. Methacrylate werden allgemein Ester der Acrylsäure bzw. Methacrylsäure bezeichnet. Beispiele verwendbarer Acrylate und Methacrylate sind Methylacrylat, Methylmethacrylat, Ethylacrylat, Ethylmethacrylat, Ethoxyethylacrylat, Ethoxyethylmethacrylat, n-Butylacrylat, n-Butylmethacrylat, tert.-Butylacrylat, tert.-Butylmethacrylat, Hexylacrylat, Hexylmethacrylat, 2-Ethylhexylacrylat, 2-Ethylhexylmethacrylat, Butoxyethylacrylat, Butoxyethylmethacrylat, Laurylacrylat, Laurylmethacrylat, Isobornylacrylat, Isobomylnethacrylat, Phenylacrylat, Phenylmethacrylat, p-Chlorphenylacrylat, p-Chlorphenylmethacrylat, p-Bromphenylacrylat, p-Bromphenyl-methacrylat, 2,4,6-Trichlorphenylacrylat,

2,4,6-Trichlorphenylmethacrylat, 2,4,6-Tribromphenyl-acrylat, 2,4,6-Tribromphenylmethacrylat, Pentachlorphenylacrylat, Pentachlorphenylmethacrylat, Pentabromphenylacrylat, Pentabromphenylmethacrylat, Pentabrombenzylacrylat, Pentabrombenzylmethacrylat, Phenoxyethylacrylat, Phenoxyethylmethacrylat, Phenoxyethoxyethylacrylat, Phenoxyethoxyethylmethacrylat, 2-Naphthylacrylat, 2-Naphthylmethacrylat, 1,4-Bis-(2-thionaphthyl)-2-butylacrylat, 1,4-Bis-(2-thionaphthyl)-2-butylmethacrylat, Propan-2,2-diylbis[(2,6-dibrom-4,1-phenylen)oxy(2-{[3,3,3-tris(4-chlorphenyl)-propanoyl]-oxy}propan-3,1-diyl)oxyethan-2,1-diyl]-diacrylat, Bisphenol A Diacrylat, Bisphenol A Dimethacrylat, Tetrabromobisphenol A Diacrylat, Tetrabromobisphenol A Dimethacrylat sowie deren ethoxylierte Analogverbindungen, N-Carbazolylacrylate um nur eine Auswahl zu nennen.

Bevorzugt werden dabei Acrylate und Methacrylate mit einem Brechungsindex $n_D^{20}$ (gemessen bei einer Wellenlänge von 405 nm) von größer 1,45 eingesetzt. Besonders bevorzugt werden Acrylate eingesetzt, die mindestens eine aromatische Struktureinheit enthalten und einen Brechungsindex $n_D^{20}$ (405 nm) von größer 1,50 haben. Als besonders geeignete Beispiele hierfür sind Acrylate und Methacrylate auf Basis von Bisphenol A oder dessen Derivate zu nennen sowie solche Acrylate und Methacrylate, die eine Thioarylgruppe enthalten.

Bevorzugt können auch Urethanacrylate als Schreibcomonomere verwendet werden. Unter Urethanacrylaten versteht man Verbindungen mit mindestens einer Acrylsäureestergruppe die zusätzlich über mindestens eine Urethanbindung verfügen. Es ist bekannt, dass solche Verbindungen durch Umsetzung eines Hydroxy-funktionellen Acrylsäureesters mit einer Isocyanat-funktionellen Verbindung erhalten werden können.

Beispiele hierfür verwendbarer Isocyanate sind aromatische, araliphatische, aliphatische und cycloaliphatische Di-, Tri- oder Polyisocyanate. Es können auch Mischungen solcher Di-, Tri- oder Polyisocyanate eingesetzt werden. Beispiele geeigneter Di-, Tri- oder Polyisocyanate sind Butylen-diisocyanat, Hexamethylendiisocyanat (HDI), Isophorondiisocyanat (IPDI), 1,8-Diisocyanato-4-(isocyanatomethyl)oktan, 2,2,4- und/oder 2,4,4-Trimethylhexamethylendiisocyanat, die isomeren Bis(4,4'-isocyanatocyclohexyl)methane und deren Mischungen beliebigen Isomerengehalts, Isocyanatomethyl-1,8-octandiisocyanat, 1,4-Cyclohexylendiisocyanat, die isomeren Cyclohexandimethylendiisocyanate, 1,4-Phenylendiisocyanat, 2,4- und/oder 2,6-Toluylendiisocyanat, 1,5-Naphthylendiisocyanat, 2,4'- oder 4,4'-Diphenylinethandiisocyanat, 1,5-Naphthylendiisocyanat, Triphenylmethan-4,4',4"-triisocyanat und Tris(p-isocyanatophenyl)thiophosphat oder deren Derivate mit Urethan-, Harnstoff-, Carbodiimid-, Acylhamstoff-, Isocyanurat-, Allophanat-, Biuret-, Oxadiazintrion-, Uretdion-, Iminooxadiazindionstruktur und Mischungen derselben. Bevorzugt sind dabei aromatische oder araliphatische Di-, Tri- oder Polyisocyanate.

Als hydroxyfunktionelle Acrylate oder Methacrylate für die Herstellung von Urethanacrylaten kommen beispielsweise in Betracht Verbindungen wie 2-Hydroxyethyl(meth)acrylat, Polyethylenoxid-mono(meth)acrylate, Polypropylenoxidmono(meth)acrylate, Polyalkylenoxid-mono(meth)-acrylate, Poly(ε-caprolacton)mono(meth)acrylate, wie z.B. Tone® M100 (Dow, Schwalbach, DE), 2-Hydroxypropyl(meth)acrylat, 4-Hydroxybutyl(meth)acrylat, 3-Hydroxy-2,2-dimethylpropyl-(meth)acrylat, Hydroxypropyl(meth)acrylat, Acrylsäure-(2-hydroxy-3-phenoxypropylester), die hydroxyfunktionellen Mono-, Di- oder Tetraacrylate mehrwertiger Alkohole wie Trimethylolpropan, Glycerin, Pentaerythrit, Dipentaerythrit, ethoxyliertes, propoxyliertes oder alkoxyliertes Trimethylolpropan, Glycerin, Pentaerythrit, Dipentaerythrit oder deren technische Gemische. Bevorzugt sind 2-Hydroxyethylacrylat, Hydroxypropylacrylat, 4-Hydroxybutylacrylat und Poly(ε-caprolacton)mono(meth)acrylate. Darüberhinaus sind als isocyanat-reaktive oligomere oder polymere ungesättigte Acrylat- und/oder Methacrylatgruppen enthaltende Verbindungen alleine oder in Kombination mit den vorgenannten monomeren Verbindungen geeignet. Ebenfalls verwendet werden können die an sich bekannten hydroxylgruppenhaltigen Epoxy(meth)acrylate mit OH-Gehalten von 20 bis 300 mg KOH/g oder hydroxylgruppenhaltige Polyurethan(meth)acrylate mit OH-Gehalten von 20 bis 300 mg KOH/g oder acrylierte Polyacrylate mit OH-Gehalten von 20 bis 300 mg KOH/g sowie deren Mischungen untereinander und Mischungen mit hydroxylgruppenhaltigen ungesättigten Polyestern sowie Mischungen mit Polyester(meth)acrylaten oder Mischungen hydroxylgruppmhaltiger ungesättigter Polyester mit Polyester(meth)acrylaten. Bevorzugt sind hydroxylgruppenhaltige Epoxyacrylate mit definierter Hydroxyfunktionalität. Hydroxylguppenhaltige Epoxy(meth)acrylate basieren insbesondere auf Umsetzungsprodukten von Acrylsäure und/oder Methacrylsäure mit Epoxiden (Glycidylverbindungen) von monomeren, oligomeren oder polymeren Bisphenol-A, Bisphenol-F, Hexandiol und/oder Butandiol oder deren ethoxylierten und/oder propoxylierten Derivaten. Bevorzugt sind weiterhin Epoxyacrylate mit definierter Funktionalität wie sie aus der bekannten Umsetzung von Acrylsäure und/oder Methacrylsäure und Glycidyl(meth)acrylat erhalten werden können.

Bevorzugt werden Mischungen von (Meth-)Acrylaten und/oder Urethan(meth-)acrylaten verwendet, besonders bevorzugt von (Meth-)Acrylaten und/oder Urethan(meth-)acrylaten, die mindestens eine aromatische Struktureinheit aufweisen.

Besonders bevorzugte als Schreibcomonomere zu verwendende Verbindungen sind Mischungen von Urethanacrylaten und Urethanmethacrylaten auf Basis aromatischer Isocyanate und 2-Hydroxyethylacrylat, Hydroxypropylacrylat, 4-Hydroxybutylacrylat, Polyethylenoxid-nono-(meth)acrylat, Polypropylenoxidmono(meth)acrylat, Polyalkylenoxidmono(meth)acrylat und Poly(ε-caprolacton)mono(meth)-acrylate.

In einer ganz besonders bevorzugten Ausführungsform werden als Schreibcomonomere die Mischungen der Additionsprodukte aromatischer Triisocyanate (ganz besonders bevorzugt Tris-(4-phenylisocyanato)-thiophosphat oder

Trimere aromatischer Diisocyanate wie Toluylendüsocyanat) mit Hydroxyethylacrylat, Hydroxypropylacrylat, 4-Hydroxybutylacrylat zusammen mit den Additionsprodukten von n 3-Thiomethyl-phenylisocyanat mit Hydroxyethylacrylat, Hydroxypropylacrylat, 4-Hydroxybutylacrylat eingesetzt (wie in den Anmeldungen WO 2008/125229 A1und in der nicht vorveröffentlichten Amneldung EP 09009651.2 beschrieben).

Weiterhin ist die Verwendung von Glycidyletheracrylaturethanen als Schreibmonomere bevorzugt. Diese gehorchen der allgemeinen Formel Ia oder Ib oder Mischungen aus Ia und Ib,

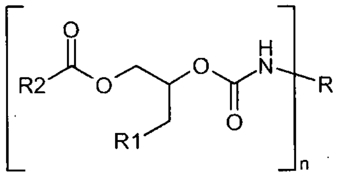

Formel Ia

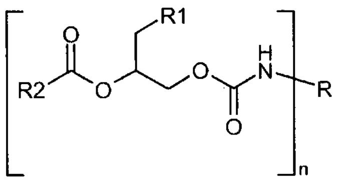

Formel Ib

wobei

n eine natürliche Zahl von 2 bis 6 ist

R1 ein ein- oder mehrkerniger Aromatengruppen haltiger organischer Rest mit 4 bis 36 Kohlenstoffatomen ist,

R2 ein olefinisch ungesättigter Rest mit 3 bis 30 Kohlenstoffatomen ist und

R ein von einem aliphatischen oder aromatischen Di- oder Polyisocyanat abgeleiteter organischer Rest mit 2 bis 30 Kohlenstoffatomen ist.

Die ungesättigten Glycidyletheracrylaturethane der Formel Ia bzw. Ib können in einer 2-Stufen Synthese hergestellt werden. In der ersten Umsetzung wird eine ungesättigte Carbonäure mit einem Epoxid zur Reaktion gebracht, wobei ein Gemisch zweier Alkohole gebildet wird. Selbstverständlich können in diesem Reaktionsschritt auch ungesättigte Epoxide mit beliebigen Carbonsäuren zum analogen Zwischenprodukt umgesetzt werden. In einem zweiten Reaktionsschritt wird dieses Alkoholgemisch mittels eines Di- oder Polyisocyanats $R(NCO)_n$ der Funktionalität n zum Glycidyletheracrylaturethan urethanisiert (wie in der nicht vorveröffentlichten Anmeldung EP 09002180.9 beschrieben). Bevorzugt werden dabei Methacrylsäure und Acrylsäure oder deren Derivate bzw. aromatische Carbonsäuren für die Umsetzung mit einem ungesättigten Epoxid eingesetzt, als Epoxide finden bevorzugt aromatische oder ungesättigte Epoxide wie Phenyl-, Dibromophenyl-, Naphthyl- oder Biphenylglycidether oder Glycidyl(meth)acrylat Anwendung und als Isocyanatkomponente verwendet man bevorzugt Toluolyldiisocyanat (TDI), Hexamethylendiisocyanat (HDI) oder Triisocyanatononan (TIN).

In einer ganz besonders bevorzugten Ausführungsform werden die Kombinationen aus (Acrylsäure, Biphenylglycidether und TDI), (Acrylsäure, Phenylglyeidether und TDI) sowie (Acrylsäure, Biphenyglycidether und HDI) verwendet.

Gemäß einer bevorzugten Ausführungsform ist vorgesehen, dass sich die Schreibmonomere in ihren jeweiligen Brechungsindizes $n_D{}^{20}$ (405 nm) um nicht mehr als 0,200, bevorzugt nicht mehr als 0,100 und insbesondere nicht mehr als 0,065 unterscheiden und jeweils einen Brechungsindex $n_D^{20}$ (405 nm) von $\geq$ 1,45, bevorzugt von $\geq$ 1,50 und besonders bevorzugt von $\geq$ 1,55 aufweisen. Mit Photopolymer-Formulierungen, die eine solche Schreibmonomer-Kombination enthalten, können besonders hohe $\Delta$n-Werte erzielt werden.

Bevorzugt ist weiterhin, wenn die Schreibmonomere Acrylate, bevorzugt Urethanacrylate sind, wobei die Acrylate insbesondere mono-, di-, tri und / oder multifunktional sein können. Unter mono-, di-, tri- und / oder multifunktional im Sinne der Erfindung ist dabei jeweils die Anzahl der Acrylgruppen pro Molekül zu verstehen, d.h. ein monofunktionales Schreibmonomer weist eine, ein difunktionales Schreibmonomer zwei, ein trifunktionales Schreibmonomer drei und ein multifunktionales Schreibmonomer mehr als 3 Acrylatgruppen auf.

Besonders bevorzugt ist, wenn die Photopolymer-Formulierung eine Kombination eines monofunktionalen und eines multifunktionalen, insbesondere di- oder trifunktionalen Urethanacrylats enthält. Es kann ebenfalls vorteilhaft sein, wenn die Kombination aus einem di- und einem trifunktionellen Schreibmonomer verwendet wird. Die aus derartigen Photopolymer-Fonnulierungen hergestellten Hologramme weisen besonders hohe Δn-Werte auf..

Bei den Matrixpolymeren kann es sich vorzugsweise um Polyurethane handeln, die insbesondere durch Umsetzung von einer Isocyanatkomponente a) mit einer Isocyanat-reaktiven Komponente b) erhältlich sind.

Bevorzugt sind weiterhin Photopolymer-Formulierungen, umfassend Matrixpolymere, erhältlich durch Umsetzung von einer Polyisocyanatkomponente a) mit einer isocyanatreaktiven Komponente b), mindestens 2 verschiedene Verbindungen, die unter Einwirkung aktinischer Strahlung mit ethylenisch ungesättigten Verbindungen unter Polymerisation reagierende Gruppen (strahlenhärtende Gruppen) aufweisen und selbst frei von NCO-Gruppen sind als Schreibmonomere c), Radikalstabilisatoren d), Photoinitiatoren e), gegebenenfalls Katalysatoren f) und gegebenenfalls Hilfs- und Zusatzstoffe g).

Die Isocyanatkomponente a) umfasst bevorzugt Polyisocyanate. Als Polyisocyanate können alle dem Fachmann an sich bekannten Verbindungen oder deren Mischungen eingesetzt werden, die im Mittel zwei oder mehr NCO-Funktionen pro Molekül aufweisen. Diese können auf aromatischer, araliphatischer, aliphatischer oder cycloaliphatischer Basis sein. In untergeordneten Mengen können auch Monoisocyanate und/oder ungesättigte Gruppen enthaltende Polyisocyanate mitverwendet werden.

Beispielsweise geeignet sind Butylendiisocyanat, Hexamethylendiisocyanat (HDI), Isophorondiisocyanat (IPDI), 1,8-Diisocyanato-4-(isocyanatomethyl)-octan, 2,2,4- und/oder 2,4,4-Trimethylhexamethylendiisocyanat, die isomeren Bis-(4,4'-isocyanatocyclohexyl)methan und deren Mischungen beliebigen Isomerengehalts, Isocyanatomethyl-l,8-octandiisocyanat, 1,4-Cyclohexylendiisocyanat, die isomeren Cyclohexandimethylendiisocyanate, 1,4-Phenylendüsocyanat, 2,4- und/oder 2,6-Toluylendiisocyanat, 1,5-Naphthylendiisocyanat, 2,4'- oder 4,4'-Diphenylmethandiisocyanat und/oder Triphenylmethan-4,4',4''-triisocyanat.

Ebenfalls möglich ist der Einsatz von Derivaten monomerer Di- oder Triisocyanate mit Urethan-, Harnstoff-, Carbodiimid-, Acylhamstoff-, Isocyanurat-, Allophanat-, Biuret-, Oxadiazintrion-, Uretdion- und/oder Iminooxadiazindionstrukturen.

Bevorzugt ist der Einsatz von Polyisocyanaten auf Basis aliphatischer und/oder cycloaliphatischer Di- oder Triisocyanate.

Besonders bevorzugt handelt es sich bei den Polyisocyanaten der Komponente a) um di- oder oligomerisierte aliphatische und/oder cycloaliphatische Di- oder Triisocyanate.

Ganz besonders bevorzugt sind Isocyanurate, Uretdione und/oder Iminooxadiazindione basierend auf HDI sowie 1,8-Diisocyanato-4-(isocyanatomethyl)-octan oder deren Mischungen.

Ebenfalls können als Komponente a) NCO-funktionelle Prepolymere mit Urethan-, Allophanat-, Biuret- und/ oder Amidgruppen eingesetzt werden. Prepolymere der Komponente a) werden in dem Fachmann an sich gut bekannter Art und Weise durch Umsetzung von monomeren, oligomeren oder Polyisocyanaten a1) mit isocyanatreaktiven Verbindungen a2) in geeigneter Stöchiometrie unter optionalem Einsatz von Katalysatoren und Lösemitteln erhalten.

Als Polyisocyanate a1) eignen sich alle dem Fachmann an sich bekannten aliphatischen, cycloaliphatischen, aromatischen oder araliphatischen Di- und Triisocyanate, wobei es unerheblich ist, ob diese mittels Phosgenierung oder nach phosgenfreien Verfahren erhalten wurden. Daneben können auch die diem Fachmann an sich gut bekannten höhermolekularen Folgeprodukte monomerer Di- und/oder Triisocyanate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur jeweils einzeln oder in beliebigen Mischungen untereinander eingesetzt werden.

Beispiele für geeignete monomere Di- oder Triisocyanate, die als Komponente a1) eingesetzt werden können, sind Butylendiisocyanat, Hexamethylendiisocyanat (HDI), Isophorondiisocyanat (IPDI), Trimethyl-hexamethylen-diisocyanat (TMDI), 1,8-Diisocyanato-4-(isocyanatomethyl)-octan, Isocyanatoinethyl-1,8-octandiisocyanat (TIN), 2,4- und/ oder 2,6-Toluen-düsocyanat.

Als isocyanatreaktive Verbindungen a2) zum Aufbau der Prepolymere werden bevorzugt OH-funktionelle Verbindungen eingesetzt. Diese sind analog den OH-funktionellen Verbindungen wie sie nachfolgend für die Komponente b) beschrieben sind.

Bevorzugte OH-funktionelle Verbindungen in a2) sind Polyester- und/oder Polyetherpolyole mit zahlenmittleren Molmassen von 200 bis 6200 g/Mol. Besonders bevorzugt sind difunktionelle Polyetherpolyole basierend auf Ethylenglykol und Propylenglykol, wobei der Propylenglykolanteil mindestens 40 Gew.-% ausmacht, sowie Polymere des Tetrahydrofurans mit zahlenmittleren Molmassen von 200 bis 4100 g/Mol sowie aliphatische Polyesterpolyole mit zahlenmittleren Molmassen von 200 bis 3100 g/Mol.

Ganz besonders bevorzugt sind difunktionelle Polyetherpolyole basierend auf Ethylenglykol und Propylenglykol, wobei der Propylenglykolanteil mindestens 80 Gew.-% ausmacht (insbesondere reine Polypropylenglykole), sowie Polymere des Tetrahydrofurans mit zahlenmittleren Molmassen von 200 bis 2100 g/Mol. Ganz besonders bevorzugt sind ebenso Additionsprodukte von Butyrolacton, ε-Caprolacton und/oder Methyl-ε-caprolacton (insbesondere ε-Caprolacton)

an 2 bis 20 Kohlenstoffatome enthaltende aliphatische, araliphatische oder cycloaliphatische di-, tri- oder polyfunktionelle Alkohole (insbesondere an difunktionelle aliphatische Alkohole mit 3 bis 12 Kohlenstoffatomen). Diese Additionsprodukte haben bevorzugt zahlenmittlere Molmassen von 200 bis 2000 g/Mol, besonders bevorzugt von 500 bis 1400 g/Mol.

Allophanate können auch im Gemisch mit anderen Prepolymeren oder Oligomeren der Komponente a1) eingesetzt werden. In diesen Fällen ist der Einsatz von OH-funktionellen Verbindungen mit Funktionalitäten von 1 bis 3,1 vorteilhaft. Beim Einsatz monofunktioneller Alkohole sind solche mit 3 bis 20 Kohlenstoffatomen bevorzugt.

Ebenfalls möglich ist der Einsatz von Aminen zur Prepolymerherstellung. Beispielsweise geeignet sind Ethylendiamin, Diethylentriamin, Triethylentetramin, Propylendiamin, Diaminocyclohexan, Diaminobenzol, Diaminobisphenyl, difunktionelle Polyamine wie z.B. die Jeffamine®, aminterminierte Polymere mit zahlenmittleren Molmassen bis 10000 g/Mol oder deren beliebige Gemische untereinander.

Zur Herstellung von biuretgruppenhaltigen Prepolymeren wird Isocyanat im Überschuss mit Amin umgesetzt, wobei eine Biuretgruppe entsteht. Als Amine eignen sich in diesem Falle für die Umsetzung mit den erwähnten Di-, Tri- und Polyisocyanaten alle oligomeren oder polymeren, primären oder sekundären, difunktionellen Amine der vorstehend genannten Art. Bevorzugt sind aliphatische Biurete auf Basis aliphatischer Amine und aliphatischer Isocyanate. Besonders bevorzugt sind niedermolekulare Biurete mit zahlenmittleren Molmassen kleiner 2000 g/Mol basierend auf aliphatischer Diaminen oder difunktionellen Polyaminen und aliphatischen Diisocyanaten, insbesondere HDI und TMDI.

Bevorzugte Prepolymere sind Urethane, Allophanate oder Biurete aus aliphatischen Isocyanat-funktionellen Verbindungen und oligomeren oder polymeren Isocyanat-reaktiven Verbindungen mit zahlenmittleren Molmassen von 200 bis 10000 g/Mol, besonders bevorzugt sind Urethane, Allophanate oder Biurete aus aliphatischen Isocyanat-funktionellen Verbindungen und Polyolen mit zahlenmittleren Molmassen von 200 bis 6200 g/Mol oder (Poly-)Aminen mit zahlenmittleren Molmassen kleiner 3000 g/Mol und ganz besonders bevorzugt sind Allophanate aus HDI oder TMDI und difunktionellen Polyetherpolyolen (insbesondere Polypropylenglykolen) mit zahlenmittleren Molmassen von 200 bis 2100 g/Mol, Urethane aus HDI oder TMDI auf Basis von Additionsprodukten von Butyrolacton, ε-Caprolacton und/oder Methyl-ε-caprolacton (insbesondere ε-Caprolacton) an 2 bis 20 Kohlenstoffatome enthaltende aliphatische, araliphatische oder cycloaliphatische di-, tri- oder polyfunktionelle Alkohole (insbesondere an difunktionelle aliphatische Alkohole mit 3 bis 12 Kohlenstoffatomen) mit zahlenmittleren Molmassen von 500 bis 3000 g/Mol, insbesondere bevorzugt von 1000 bis 2000 g/Mol (insbesondere im Gemisch mit anderen Oligomeren difunktioneller aliphatischer Isocyanate) oder Urethane aus HDI oder TMDI auf Basis trifunktioneller Polyetherpolyole (insbesondere Polypropylenglykol) mit zahlenmittleren Molmassen zwischen 2000 und 6200 g/Mol sowie Biurete aus HDI oder TMDI mit difunktionellen Aminen oder Polyaminen mit zahlenmittleren Molmassen von 200 bis 1400 g/Mol (insbesondere auch im Gemisch mit anderen Oligomeren difunktioneller aliphatischer Isocyanate).

Bevorzugt weisen die vorstehend beschriebenen Prepolymere Restgehalte an freiem monomeren Isocyanat von weniger als 2 Gew.-%, besonders bevorzugt weniger als 1,0 Gew.-%, ganz besonders bevorzugt weniger als 0,5 Gew.-% auf.

Selbstverständlich kann die Isocyanatkomponente anteilsmäßig neben den beschriebenen Prepolymeren weitere Isocyanatkomponenten enthalten. Hierfür kommen in Betracht aromatische, araliphatische, aliphatische und cycloaliphatische Di-, Tri- oder Polyisocyanate verwendet. Es können auch Mischungen solcher Di-, Tri- oder Polyisocyanate eingesetzt werden. Beispiele geeigneter Di-, Tri- oder Polyisocyanate sind Butylendiisocyanat, Hexamethylendiisocyanat (HDI), Isophorondiisocyanat (IPDI), 1,8-Diisocyanato-4-(isocyanatomethyl)octan, 2,2,4- und/oder 2,4,4-Trimethylhexamethylendiisocyanat (TMDI), die isomeren Bis(4,4'-isocyanatocyclohexyl)methane und deren Mischungen beliebigen Isomerengehalts, Isocyanatomethyl-1,8-octaudiisocyanat, 1,4-Cyclohexylendiisocyanat, die isomeren Cyclohexandimethylendiisocyanate, 1,4-Phenylendiisocyanat, 2,4- und/oder 2,6-Toluylendiisocyanat, 1,5-Naphthylendiisocyanat, 2,4'- oder 4,4'-Diphenylmethandiisocyanat, Triphenylmethan-4,4',4"-triisocyanat oder deren Derivate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur und Mischungen derselben. Bevorzugt sind Polyisocyanate auf Basis oligomerisierter und/oder derivatisierter Diisocyanate, die durch geeignete Verfahren von überschüssigem Diisocyanat befreit wurden, insbesondere die des Hexamethylendiisocyanat. Besonders bevorzugt sind die oligomeren Isocyanurate, Uretdione und Iminooxadiazindione des HDI sowie deren Mischungen.

Es ist gegebenenfalls auch möglich, dass die Isocyanatkomponente a) anteilsmäßig Isocyanate enthält, die teilweise mit isocyanat-reaktiven ethylenisch ungesättigten Verbindungen umgesetzt sind. Bevorzugt werden hierbei als isocyanat-reaktives ethylenisch ungesättigten Verbindungen α,β-ungesättigte Carbonsäurederivate wie Acrylate, Methacrylate, Maleinate, Fumarate, Maleimide, Acrylamide, sowie Vinylether, Propenylether, Allylether und Dicyclopentadienyl-Einheiten enthaltende Verbindungen, die mindestens eine gegenüber Isocyanaten reaktive Gruppe aufweisen, eingesetzt, besonders bevorzugt sind dies Acrylate und Methacrylate mit mindestens einer isocyanatreaktiven Gruppe. Als hydroxyfunktionelle Acrylate oder Methacrylate kommen beispielsweise Verbindungen wie 2-Hydroxyethyl(meth)acrylat, Polyethylenoxid-mono-(meth)acrylate, Polypropylenoxidmono(meth)acrylate, Polyalkylenoxidmono(meth)acrylate, Poly(ε-caprolacton)mono(meth)acrylate, wie z. B. Tone® M100 (Dow, USA), 2-Hydroxypropyl(meth)acrylat, 4-Hydroxybutyl(meth)acrylat, 3-Hydroxy-2,2-dimethylpropyl(meth)acrylat, die hydroxyfunktionellen Mono-, Di- oder Tetra(meth)acrylate mehrwertiger Alkohole wie Trimethylolpropan, Glycerin, Pentaerythrit, Dipentaerythrit, ethoxyliertes, propoxyliertes oder alkoxyliertes Trimethylolpropan, Glycerin, Pentaerythrit, Dipentaerythrit oder deren technische Gemische in Betracht. Darüberhinaus sind isocyanat-reaktive oligomere oder polymere ungesättigte Acrylat- und/oder Methacrylatgruppen enthaltende Verbindungen alleine oder in Kombination mit den vorgenannten monomeren Verbindungen geeignet. Der Anteil an Isocyanaten die teilweise mit isocyanat-reaktiven ethylenisch ungesättigten Verbindungen umgesetzt sind an der Isocyanatkomponente a) beträgt 0 bis 99 %, bevorzugt 0 bis 50 %, besonders bevorzugt 0 bis 25 % und ganz besonders bevorzugt 0 bis 15 %.

Es ist gegebenenfalls auch möglich, dass die vorgenannten Isocyanatkomponente a) vollständig oder anteilsmäßig Isocyanate enthält, die ganz oder teilweise mit dem Fachmann aus der Beschichtungstechnologie bekannten Blockierungsmitteln umgesetzt sind. Als Beispiel für Blockierungsmittel seien genannt: Alkohole, Lactame, Oxime, Malonester, Alkylacetoacetate, Triazole, Phenole, Imidazole, Pyrazole sowie Amine, wie z.B. Butanonoxim, Diisopropylamin, 1,2,4-Triazol, Dimethyl-1,2,4-triazol, Imidazol, Malonsäurediethylester, Acetessigester, Acetonoxim, 3,5-Dimethylpyrazol, ε-Caprolactam, N-tert.-Butyl-benzylamin, Cyclopentanoncarboxyethylester oder beliebige Gemische dieser Blockierungsmittel.

Als Komponente b) können an sich alle polyfunktionellen, isocyanatreaktiven Verbindungen eingesetzt werden, die im Mittel wenigstens 1.5 isocyanatreaktive-Gruppen pro Molekül aufweisen.

Isocyanatreaktive Gruppen im Rahmen der vorliegenden Erfindung sind bevorzugt Hydroxy-, Amino- oder Thiogruppen, besonders bevorzugt sind Hydroxyverbindungen.

Geeignete polyfunktionelle, isocyanatreaktive Verbindungen sind beispielsweise Polyester-, Polyether-, Polycarbonat-, Poly(meth)acrylat- und/oder Polyurethanpolyole.

Daneben sind als Bestandteile der Komponente b) als polyfunlctionelle, isocyanatreaktive Verbindungen auch niedermolekulare, d.h. init Molekulargewichten kleiner 500 g/mol, kurzkettige, d.h. 2 bis 20 Kohlenstoffatome enthaltende aliphatische, araliphatische oder cycloaliphatische di, tri oder polyfunktionelle Alkohole geeignet.

Dies können beispielsweise sein Ethylenglykol, Diethylenglykol, Triethylenglykol, Tetraethylenglykol, Dipropylenglykol, Tripropylenglykol, 1,2-Propandiol, 1,3-Propandiol, 1,4-Butandiol, Neopentylglykol, 2-Ethyl-2-butylpropandiol, Trimethylpentandiol, stellungsisomere Diethyloctandiole, 1,3-Butylenglykol, Cyclohexandiol, 1,4-Cyclohexandimethanol, 1,6-Hexandiol, 1,2- und 1,4-Cyclohexandiol, hydriertes Bisphenol A (2,2-Bis(4-hydroxycyclohexyl)propan), 2,2-Dimethyl-3-hydroxypropionsäure (2,2-dimethyl-3-hydroxypropylester). Beispiele geeigneter Triole sind Trimethylolethan, Trimethylolpropan oder Glycerin. Geeignete höherfunktionelle Alkohole sind Ditrimethylolpropan, Pentaerythrit, Dipentaerythrit oder Sorbit.

Als Polyesterpolyole sind beispielsweise lineare Polyesterdiole oder verzweigte Polyesterpolyole geeignet, wie sie in bekannter Weise aus aliphatischen, cycloaliphatischen oder aromatischen Di- bzw. Polycarbonsäuren bzw. ihren Anhydriden mit mehrwertigen Alkoholen einer OH-Funktionalität ≥ 2 erhalten werden.

Beispiele für solche Di- bzw. Polycarbonsäuren bzw. Anhydride sind Bernstein-, Glutar-, Adipin-, Pimelin-, Kork-, Azelain-, Sebacin-, Nonandicarbon-, Decandicarbon-, Terephthal-, Isophthal-, o-Phthal-, Tetrahydrophthal-, Hexahydrophthal- oder Trimellitsäure sowie Säureanhydride wie o-Phthal-, Trimellit- oder Bernsteinsäureanhydrid oder deren beliebige Gemische untereinander. Beispiele für solche geeigneten Alkohole sind Ethandiol, Di-, Tri-, Tetraethylenglykol, 1,2-Propandiol,Di-, Tri-, Tetrapropylenglykol, 1,3-Propandiol, Butandiol-1,4, Butandiol-1,3, Butandiol-2,3, Pentandiol-1,5, Hexandiol-1,6, 2,2-Dimethyl-1,3-propandiol, 1,4-Dihydroxycyclohexan, 1,4-Dimethylolcyclohexan, Octandiol-1,8, Decandiol-1,10, Dodecandiol-1,12, Trimethylolpropan, Glycerin oder deren beliebige Gemische untereinander.

Bevorzugte Polyesterpolyole basieren auf aliphatischen Alkoholen und Mischungen aus aliphatischen und aromatischen Säuren und haben zahlenmittlere Molmassen zwischen 500 und 10000 g/Mol und Funktionalitäten zwischen 1,8 und 6,1.

Besonders bevorzugte Polyesterpolyole basieren auf aliphatischen Diolen wie Butan-1,4-diol, Hexan-1,6-diol, Neopentylglykol, Ethandiol, Propylenglykol, 1,3-Butylenglykol, Di-, Tri-, Polyethylenglykol, Di-, Tri- und/oder Tetrapropylenglykol oder Mischungen aus vorgenannten Diolen mit aliphatischen höherfunktionellen Alkoholen wie Trimethylolpropan und/oder Pentaerythrit, wobei der Anteil der höherfunktionellen Alkohole bevorzugt kleiner 50 Gewichtsprozent (insbesondere bevorzugt kleiner 30 Gewichtsprozent) bezogen auf die Gesamtmenge des eingesetzten Alkohols ausmacht, in Verbindung mit aliphatischen Di- bzw. Polycarbonsäuren bzw. Anhydriden wie Adipinsäure und/oder Bernsteinsäure oder Mischungen aus vorgenannten aliphatischen Polycarbonsäuren bzw. Anhydriden mit aromatischen Polycarbonsäuren bzw. Anhydriden wie Terephthalsäure und/oder Isophthalsäure wobei der Anteil der aromatischen Polycarbonsäuren bzw. Anhydride bevorzugt kleiner 50 Gewichtsprozent (insbesondere bevorzugt kleiner 30 Gewichtsprozent) bezogen auf die Gesamtmenge der eingesetzten Polycarbonsäuren bzw. Anhydride ausmacht. Besonders bevorzugte Polyesterpolyole haben zahlenmittlere Molmassen zwischen 1000 und 6000 g/Mol und Funktionalitäten zwischen 1,9 und 3,3.

Die Polyesterpolyole können auch auf natürlichen Rohstoffen wie Rizinusöl basieren. Ebenfalls möglich ist, dass die Polyesterpolyole auf Homo- oder Mischpolymerisaten von Lactonen basieren, wie sie bevorzugt durch Anlagerung von Lactonen bzw. Lactongemischen im Rahmen einer ringöffnenden Lacton-Polymerisation wie Butyrolacton,

ε-Caprolacton und/oder Methyl-ε-caprolacton an hydroxyfunktionelle Verbindungen wie mehrwertige Alkohole einer OH-Funktionalität ≥ 2 oder Polyole eine Funktionalität von größer 1,8 beispielsweise der vorstehend genannten Art erhalten werden können.

Bevorzugte Polyole, die hier als Starter eingesetzt werden, sind Polyetherpolyole einer Funktionalität von 1,8 bis 3,1 mit zahlenmittleren Molmassen von 200 bis 4000 g/mol, besonders bevorzugt sind Poly(tetrahydrofurane) mit einer Funktionalität von 1,9 bis 2,2 und zahlenmittleren Molmassen von 500 bis 2000 g/mol (insbesondere 600 bis 1400 g/mol). Als Anlagerungsprodukte sind Butyrolacton, ε-caprolacton und/oder Methyl-ε-caprolacton, ε-Caprolacton ist besonders bevorzugt.

Solche Polyesterpolyole haben bevorzugt zahlenmittlere Molmassen von 400 bis 6000 g/Mol, besonders bevorzugt von 800 bis 3000 g/Mol. Ihre OH-Funktionalität beträgt bevorzugt 1.8 bis 3.5, besonders bevorzugt 1.9 bis 2.2.

Geeignete Polycarbonatpolyole sind in an sich bekannter Weise durch Umsetzung von organischen Carbonaten oder Phosgen mit Diolen oder Diol-Mischungen zugänglich.

Geeignete organische Carbonate sind Dimethyl-, Diethyl- und Diphenylcarbonat.

Geeignete Diole bzw. Mischungen umfassen die an sich im Rahmen der Polyestersegmente genannten mehrwertigen Alkoholen einer OH-Funktionalität ≥ 2, bevorzugt 1,4-Butandiol, 1,6-Hexandiol und/oder 3-Methylpentandiol, oder auch Polyesterpolyole können zu Polycarbonatpolyolen umgearbeitet werden.

Solche Polycarbonatpolyole haben bevorzugt zahlenmittlere Molmassen von 400 bis 4000 g/Mol, besonders bevorzugt von 500 bis 2000 g/Mol. Die OH-Funktionalität dieser Polyole beträgt bevorzugt 1.8 bis 3.2, besonders bevorzugt 1.9 bis 3.0.

Geeignete Polyetherpolyole sind gegebenenfalls blockweise aufgebaute Polyadditionsprodukte cyclischer Ether an OH- oder NH-funktionelle Startermoleküle.

Geeignete cyclische Ether sind beispielsweise Styroloxide, Ethylenoxid, Propylenoxid, Tetrahydrofuran, Butylenoxid, Epichlorhydrin, sowie ihre beliebigen Mischungen.

Als Starter können die an sich im Rahmen der Polyesterpolyole genannten mehrwertigen Alkohole einer OH-Fmktionalität ≥ 2 sowie primäre oder sekundäre Amine und Aminoalkohole verwendet werden.

Bevorzugte Polyetherpolyole sind solche der vorgenannten Art ausschließlich basierend auf Propylenoxid oder statistische oder Block-Copolymere basierend auf Propylenoxid mit weiteren 1-Alkylenoxiden, wobei der 1-Alykenoxidanteil nicht höher als 80 Gew.-% ist. Besonders bevorzugt sind Propylenoxid-homopolymere sowie statistische oder Block-Copolymere, die Oxyethylen-, Oxypropylen- und/oder Oxybutyleneinheiten aufweisen, wobei der Anteil der Oxypropyleneinheiten bezogen auf die Gesamtmenge aller Oxyethylen-, Oxypropylen- und Oxybutyleneinheiten mindestens 20 Gew.%, bevorzugt mindestens 45 Gew.-% ausmacht. Oxypropylen- und Oxybutylen- umfasst hierbei alle jeweiligen linearen und verzweigten C3- und C4-Isomere.

Solche Polyetherpolyole haben bevorzugt zahlenmittlere Molmassen von 250 bis 10000 g/Mol, besonders bevorzugt von 500 bis 8500 g/Mol und ganz besonders bevorzugt von 600 bis 4500 g/Mol. Die OH-Funktionalität beträgt bevorzugt 1.5 bis 4.0, besonders bevorzugt 1.8 bis 3.1 und ganz besonders bevorzugt 1.9 bis 2.2.

Als spezielle Polyetherpolyole werden bevorzugt solche eingesetzt, die aus einer isocyanatreaktiven Komponente umfassend hydroxyfunktionelle Multiblockcopolymere des Typs Y(Xi-H)n mit i = 1 bis 10 und n = 2 bis 8 und zahlenmittleren Molekulargewichten von größer 1500 g/Mol bestehen, wobei die Segmente Xi jeweils aus Oxyalkyleneinheiten der Formel II aufgebaut sind,

-CH2-CH(R)-O-        Formel II

wobei R ein Wasserstoff-, Alkyl-, oder Arylrest, ist, der auch substituiert oder durch Heteroatome (wie Ethersauerstoffe) unterbrochen sein kann, Y der zugrundeliegende Starter ist und der Anteil der Segmente Xi bezogen auf die Gesamtmenge der Segmente Xi und Y wenigstens 50 Gew.-% ausmacht.

Die äußeren Blöcke $X_i$ machen dabei zumindest 50 Gew.-%, bevorzugt 66 Gew.-% der Gesamtmolmasse von $Y(X_i\text{-}H)_n$ aus und bestehen aus Monomereinheiten, die der Formel II gehorchen. Bevorzugt ist n in $Y(X_i\text{-}H)_n$ eine Zahl von 2 bis 6, besonders bevorzugt 2 oder 3 und ganz besonders bevorzugt gleich 2. Bevorzugt ist i in $Y(X_i\text{-}H)_n$ eine Zahl von 1 bis 6, besonders bevorzugt von 1 bis 3 und ganz besonders bevorzugt gleich 1.

In Formel II ist R bevorzugt ein Wasserstoff, eine Methyl-, Butyl-, Hexyl- oder Octylgruppe oder ein ethergruppenhaltiger Alkylrest. Bevorzugte ethergruppenhaltiger Alkylreste sind solche basierend auf Oxyalkyleneinheiten.

Die Multiblockcopolymere $Y(X_i\text{-}H)_n$ haben bevorzugt zahlenmittlere Molekulargewichte von mehr als 1200 g/Mol, besonders bevorzugt mehr als 1950 g/Mol, jedoch bevorzugt nicht mehr als 12000 g/Mol, besonders bevorzugt nicht mehr als 8000 g/Mol.

Die Blöcke $X_i$ können Homopolymere aus ausschließlich gleichen Oxyalkylen-Wiederholungseinheiten sein. Sie können auch statistisch aus verschiedenen Oxyalkyleneinheiten oder ihrerseits blockweise aus verschiedenen Oxyalkyleneinheiten aufgebaut sein.

Bevorzugte basieren die Segmente $X_i$ ausschließlich auf Propylenoxid oder statistischen oder blockweisen

Mischungen von Propylenoxid mit weiteren 1-Alkylenoxiden, wobei der Anteil an weiteren 1-Alykenoxiden nicht höher als 80 Gew.-% ist.

Besonders bevorzugt sind als Segmente $X_i$ Propylenoxid-homopolymere sowie statistische oder Block-Copolymere, die Oxyethylen- und/oder Oxypropyleneinheiten, wobei der Anteil der Oxypropyleneinheiten bezogen auf die Gesamtmenge aller Oxyethylen- und Oxypropyleneinheiten mindestens 20 Gew.-%, bevorzugt mindestens 40 Gew.-% ausmacht.

Die Blöcke $X_i$ werden wie weiter unten beschrieben durch ringöffnende Polymerisation der vorstehend beschriebenen Alkylenoxide auf einen n-fach hydroxy- oder aminofunktionellen Starterblock $Y(H)_n$ aufaddiert.

Der innere Block Y, der zu kleiner 50 Gew.-%, bevorzugt aus kleiner 34 Gew.-% in $Y(X_i\text{-}H)_n$ enthalten ist, besteht aus di- und/oder höher hydroxyfunktionellen Polymerstrukturen auf Basis cyclischer Ether oder ist aufgebaut aus di- und/oder höher hydroxyfunktionellen Polycarbonat-, Polyester-, Poly(meth)acrylat-, Epoxydharz- und/oder Polyurethanstruktureinheiten oder entsprechenden Hybriden.

Geeignete Polyesterpolyole sind lineare Polyesterdiole oder verzweigte Polyesterpolyole, wie sie in bekannter Weise aus aliphatischen, cycloaliphatischen oder aromatischen Di- bzw. Polycarbonsäuren bzw. ihren Anhydriden wie z. B. Bernstein-, Glutar-, Adipin-, Pimelin-, Kork-, Azelain-, Sebacin-, Nonandicarbon-, Decandicarbon-, Terephthal-, Isophthal-, o-Phthal-, Tetrahydrophthal-, Hexahydrophthal- oder Trimellitsäure sowie Säureanhydride wie o-Phthal-, Trimellit- oder Bernsteinsäureanhydrid oder deren beliebiger Gemische mit mehrwertigen Alkoholen wie z. B. Ethandiol, Di-, Tri-, Tetraethylenglykol, 1,2-Propandiol, Di-, Tri-, Tetrapropylenglykol, 1,3-Propandiol, Butandiol-1,4, Butandiol-1,3, Butandiol-2,3, Pentandiol-1,5, Hexandiol-1 , 6 , 2 , 2-Dimethyl-1,3-propandiol, 1,4-Dihydroxycyclohexan, 1,4-Dimethylolcyclohexan, Octandiol-1,8, Decandiol-1,10, Dodecandiol-1,12 oder deren Gemische gegebenenfalls unter Mitverwendung höherfunktioneller Polyole wie Trimethylolpropan oder Glycerin hergestellt werden können. Als mehrwertige Alkohole zur Herstellung der Polyesterpolyole kommen natürlich auch cycloaliphatische und/oder aromatische Di- und Polyhydroxylverbindungen in Frage. Anstelle der freien Polycarbonsäure können auch die entsprechenden Polycarbonsäureanhydride oder entsprechende Polycarbonsäureester von niedrigen Alkoholen oder deren Gemische zur Herstellung der Polyester verwendet werden.

Die Polyesterpolyole können auch auf natürlichen Rohstoffen wie Rizinusöl basieren. Ebenfalls möglich ist, dass die Polyesterpolyole auf Homo- oder Mischpolymerisaten von Lactonen basieren, wie sie bevorzugt durch Anlagerung von Lactonen bzw. Lactongemischen wie Butyrolacton, ε-Caprolacton und/oder Methyl-ε-caprolacton an hydroxyfunktionelle Verbindungen wie mehrwertige Alkohole einer OH-Funktionalität von bevorzugt 2, beispielsweise der vorstehend genannten Art, erhalten werden können.

Solche Polyesterpolyole haben bevorzugt zahlenmittlere Molmassen von 200 bis 2000 g/Mol, besonders bevorzugt von 400 bis 1400 g/Mol.

Geeignete Polycarbonatpolyole sind in an sich bekannter Weise durch Umsetzung von organischen Carbonaten oder Phosgen mit Diolen oder Diol-Mischungen zugänglich.

Geeignete organische Carbonate sind Dimethyl-, Diethyl- und Diphenylcarbonat.

Geeignete Diole bzw. Mischungen umfassen die an sich im Rahmen der Polyesterpolyole genannten mehrwertigen Alkohole einer OH-Funktionalität von 2, bevorzugt 1,4-Butandiol, 1,6-Hexandiol und/oder 3-Methylpentandiol. Polyesterpolyole können auch zu Polycarbonatpolyolen umgearbeitet werden. Besonders bevorzugt werden bei der Umsetzung der genannten Alkohole zu Polycarbonatpolyolen Dimethyl- oder Diethylcarbonat eingesetzt.

Solche Polycarbonatpolyole haben bevorzugt zahlenmittlere Molmassen von 400 bis 2000 g/Mol, besonders bevorzugt von 500 bis 1400 g/Mol und ganz besonders bevorzugt von 650 bis 1000 g/Mol.

Geeignete Polyetherpolyole sind gegebenenfalls blockweise aufgebaute Polyadditionsprodukte cyclischer Ether an OH- oder NH-funktionelle Startermoleküle. Als Polyetherpolyole seien z. B. die Polyadditionsprodukte der Styroloxide, des Ethylenoxid, Propylenoxid, Tetrahydrofuran, Butylenoxid, Epichlorhydrins, sowie ihre Mischadditions- und Pfropfprodukte, sowie die durch Kondensation von mehrwertigen Alkoholen oder Mischungen derselben und die durch Alkoxylierung von mehrwertigen Alkoholen, Aminen und Aminoalkoholen gewonnenen Polyetherpolyole.

Geeignete Polymere cyclischer Ether sind insbesondere Polymere des Tetrahydrofuran.

Als Starter können die an sich im Rahmen der Polyesterpolyole genannten mehrwertigen Alkohole sowie primäre oder sekundäre Amine und Aminoalkohole einer OH- oder NH-Funktionalität von 2 bis 8, bevorzugt 2 bis 6, besonders bevorzugt 2 bis 3, ganz besonders bevorzugt gleich 2 verwendet werden.

Solche Polyetherpolyole haben bevorzugt zahlenmittlere Molinassen von 200 bis 2000 g/Mol, besonders bevorzugt von 400 bis 1400 g/Mol und ganz besonders bevorzugt von 650 bis 1000 g/Mol.

Als für Starter verwendete Polyetherpolyole werden bevorzugt die Polymere des Tetrahydrofuran eingesetzt.

Selbstverständlich können auch Mischungen der oben beschriebenen Komponenten für den inneren Block Y eingesetzt werden.

Bevorzugte Komponenten für den inneren Block Y sind Polymere des Tetrahydrofuran sowie aliphatische Polycarbonatpolyole und Polyesterpolyole sowie Polymere des ε-Caprolacton mit zahlenmittleren Molmassen kleiner 3100 g/Mol.

Besonders bevorzugte Komponenten für den inneren Block Y sind difunktionelle Polymere des Tetrahydrofuran sowie difunktionelle aliphatische Polycarbonatpolyole und Polyesterpolyole sowie Polymere des ε-Caprolacton mit zahlenmittleren Molmassen kleiner 3100 g/Mol.

Ganz besonders bevorzugt basiert das Startersegment Y auf difunktionellen, aliphatischen Polycarbonatpolyolen, Poly(ε-Caprolacton) oder Polymeren des Tetrahydrofurans mit zahlenmittleren Molmassen größer 500 g/Mol und kleiner 2100 g/Mol.

Bevorzugt eingesetzte Blockcopolymere der Struktur $Y(X_i\text{-}H)_n$ bestehen zu mehr als 50 Gewichtsprozent aus den oben als beschriebenen Blöcken $X_i$ und haben eine zahlenmittlere Gesamtmolmasse von größer 1200 g/Mol.

Besonders bevorzugte Blockcopolyole bestehen zu weniger als 50 Gewichtsprozent aus aliphatischem Polyester, aliphatischem Polycarbonatpolyol oder Poly-THF und zu mehr als 50 Gewichtsprozent aus den oben als erfindungsgemäß beschriebenen Blöcken $X_i$ und haben eine zahlenmittlere Molmasse von größer 1200 g/Mol. Besonders bevorzugte Blockcopolymere bestehen bestehen zu weniger als 50 Gewichtsprozent aliphatischem Polycarbonatpolyol, Pols(ε-Caprolacton) oder Poly-THF und zu mehr als 50 Gewichtsprozent aus den oben als erfindungsgemäß beschriebenen Blöcken $X_i$ und haben eine zahlemnittlere Molmasse von größer 1200 g/Mol.

Ganz besonders bevorzugte Blockcopolymere bestehen zu weniger als 34 Gewichtsprozent aus aliphatischem Polycarbonatpolyol, Poly(ε-Caprolacton) oder Poly-THF und zu mehr als 66 Gewichtsprozent aus den oben als erfindungsgemäß beschriebenen Blöcken $X_i$ und haben eine zahlenmittlere Mohnasse von größer 1950 g/Mol und weniger als 9000 g/Mol.

Die beschriebenen Blockcopolyole werden durch Alkylenoxidadditionsverfahren hergestellt. Von großtechnischer Bedeutung ist zum einen die basisch katalysierte Anlagerung von Alkylenoxiden an Starterverbindungen mit Zerewitinoff-aktiven Wasserstoffatomen $Y(H)_n$, zum anderen die gewinnt die Verwendung von Doppelmetallcyanidverbindungen ("DMC-Katalysatoren") für die Durchführung dieser Reaktion zunehmend an Bedeutung. An N, O oder S gebundener Wasserstoff wird als Zerewitinoff-aktiver Wasserstoff (manchmal auch nur als "aktiven Wasserstoff") bezeichnet, wenn er nach einem von Zerewitinoff aufgefundenen Verfahren durch Umsetzung mit Methylmagnesiumjodid Methan liefert. Typische Beispiele für Verbindungen mit Zerewitinoffaktivem Wasserstoff sind Verbindungen, die Carboxyl-, Hydroxyl-, Amino-, Imino- oder Thiol-Gruppen als funktionelle Gruppen enthalten. Die basisch katalysierte Anlagerung von Alkylenoxiden wie beispielsweise Ethylenoxid oder Propylenoxid an Starterverbindungen mit Zerewitinoff-aktiven Wasserstoffatomen erfolgt in Gegenwart von Alkalimetallhydroxiden, es können aber auch Alkalimetallhydride, Alkalimetallcarboxylate oder Erdalkalihydroxide verwendet werden. Nach erfolgter Anlagerung der Alkylenoxide müssen die polymerisationsaktiven Zentren an den Polyetherketten deak-tiviert werden, beispielsweise durch Neutralisation mit verdünnten Mineralsäuren wie Schwefelsäure oder Phosphorsäure und Abtrennung der entstehenden Salze. Im erfindungsgemäßen Verfahren werden bevorzugt DMC-Katalysatoren verwendet. Besonders bevorzugt eingesetzt werden hochaktive DMC-Katalysatoren, die z.B. beschrieben sind in US-A 5 470 813, EP-A 700 949, EP-A 743 093, EP-A 761 708, WO 97/40086, WO 98/16310 und WO 00/47649. Ein typisches Beispiel sind die in EP-A 700 949 beschriebenen hochaktiven DMC-Katalysatoren, die neben einer Doppelmetallcyanid-Verbindung (z.B. Zinkhexacyanocobaltat(III)) und einem organischen Komplexliganden (z.B. tert.-Butanol) noch einen Polyether mit einem zahlenmittlerem Molekulargewicht größer als 500 g/Mol enthalten. Diese Katalysatoren können aufgrund ihrer hohen Aktivität in solch kleinen Mengen eingesetzt werden, dass eine weitere Aufarbeitung der Polyetherpolyole nicht erforderlich ist. Das Verfahren ist unten ausführlicher beschrieben. Als "Starterpolyol" wird dabei stets die zu weniger als 50 Gewichtsprozent im Blockcopolymer enthaltene OH-funktionalisierte Vorstufe Y eingesetzt, auf die Alkylenoxid aufpolymerisiert witrd, so dass am Ende ein Multiblockcopolymer erhalten wird. Als Alkylenoxide kommen bevorzugt Ethylenoxid, Propylenoxid, Butylenoxid sowie deren Mischungen zum Einsatz. Der Aufbau der Polyetherketten durch Alkoxylierung kann z.B. nur mit einem monomeren Epoxid durchgeführt werden oder auch statistisch oder blockweise mit mehreren unterschiedlichen monomeren Epoxiden erfolgen.

Bevorzugte Kombinationen aus Komponente a) und b) bei der Herstellung der Matrixpolymere sind:

A) Additionsprodukte von Butyrolacton, ε-Caprolacton und/oder Methyl-ε-caprolacton an Polyetherpolyolen einer Funktionalität von 1,8 bis 3,1 mit zahlenmittleren Molmassen von 200 bis 4000 g/mol in Verbindung mit Isocyanuraten, Uretdionen, Iminooxadiazindionen und/oder anderen Oligomeren basierend auf HDI. Besonders bevorzugt Additionsprodukte von ε-Caprolacton an Poly(tetrahydrofurane) mit einer Funktionalität von 1,9 bis 2,2 und zahlemnittleren Molmassen von 500 bis 2000 g/mol (insbesondere 600 bis 1400 g/mol), deren zahlenmittlere Gesamtmolmasse von 800 bis 4500 g/Mol, insbesondere von 1000 bis 3000 g/Mol liegt in Verbindung mit Oligomeren, Isocyanuraten und/oder Iminooxadiazindionen basierend auf HDI.

B) Polyesterpolyole basierend auf Butan-1,4-diol, Hexan-1,6-diol, Neopentylglykol, Di-, Tri-, Polyethylenglykol mit zahlenmittlerer Molmasse kleiner 500 g/Mol, Tri- und/oder Tetrapropylehglykol in Verbindung mit aliphatischen Di- bzw. Polycarbonsäuren bzw. Anhydriden wie Adipinsäure und/oder Bernsteinsäure oder Mischungen aus vorgenannten aliphatischen Polycarbonsäuren bzw. Anhydriden mit aromatischen Polycarbonsäuren bzw. Anhydriden

wie Terephthalsäure und/oder Isophthalsäure wobei der Anteil der aromatischen Polycarbonsäuren bzw. Anhydride bevorzugt kleiner 30 Gewichtsprozent bezogen auf die Gesamtmenge der eingesetzten Polycarbonsäuren bzw. Anhydride ausmacht, mit zahlenmittleren Molmassen zwischen 1000 und 4000 g/Mol und Funktionalitäten zwischen 1,9 und 3,0 in Verbindung mit Oligomeren, Isocyanuraten und/oder Iminooxadiazindionen basierend auf HDI.

C) Polyetherpolyole mit zahlemnittlere Molmassen von 500 bis 8500 g/Mol und OH-Funktionalitäten von 1,8 bis 3,2, ausschließlich basierend auf Propylenoxid oder statistische oder Block-Copolyole basierend auf Propylenoxid und Ethylenoxid, wobei der Ethylenoxidanteil nicht höher als 60 Gew.-% ist in Verbindung mit Urethanen, Allophanaten oder Biureten aus aliphatischen Isocyanat-funktionellen Verbindungen und oligomeren oder polymeren Isocyanat-reaktiven Verbindungen mit zahlenmittleren Molmassen von 200 bis 6000 g/Mol. Besonders bevorzugt sind Propylenoxid-homopolymere mit zahlenmittlere Molmassen von 1800 bis 4500 g/Mol und OH-Funktionalitäten von 1,9 bis 2,2 in Verbindung mit Allophanaten aus HDI oder TMDI und difunktionellen Polyetherpolyolen (insbesondere Polypropylenglykolen) mit zahlenmittleren Molmassen von 200 bis 2100 g/Mol.

D) Polyetherblock- oder -multiblockcopolymere der Formel II, wobei Y ein rein aliphatisches Polycarbonatpolyol oder ein Polymer des Tetrahydrofurans mit jeweils einer OH-Funktionalität von 1,8 bis 3,1 und einer zahlenmittlere Molmassen von 400 bis 2000 g/Mol ist, n = 2, i = 1 oder 2 und R = Methyl oder H ist, mit einer gesamten zahlenmittleren Molmasse von 1950 bis 9000 g/Mol, bevorzugt von 1950 bis 6000 g/Mol, in Verbindung mit Urethanen, Allophanaten oder Biureten aus aliphatischen Isocyanat-funktionellen Verbindungen und oligomeren oder polymeren Isocyanat-reaktiven Verbindungen mit zahlenmittleren Molmassen von 200 bis 6000 g/Mol oder in Verbindung mit Isocyanuraten, Uretdionen, Iminooxadiazindionen und/oder anderen Oligomeren basierend auf HDI. Besonders bevorzugt sind Polyetherblock- oder -multiblockcopolymere der Formel II, wobei Y ein rein aliphatisches Polycarbonatpolyol auf Basis 1,4-Butandiol und/oder 1,6-Hexandiol mit Dimethyl- oder Diethylcarbonat oder ein Polymer des Tetrahydrofurans mit einer OH-Funktionalität von 1,8 bis 2,2 und einer zahlenmittlere Molmassen von 600 bis 1400 g/Mol (insbesondere bis 1000 g/Mol) ist, n = 2, i = 1 oder 2 und R = Methyl oder H ist, wobei der Anteil der Ethylenoxideinheiten an der Gesamtmasse von $X_i$ nicht höher als 60 Gew.% ist, in Verbindung mit Allophanaten aus HDI oder TMDI und difunktionellen Polyetherpolyolen (insbesondere Polypropylenglykolen) mit zahlenmittleren Molmassen von 200 bis 2100 g/Mol, in Verbindung mit Biureten mit zahlenmittleren Molmassen von 200 bis 1400 g/Mol (insbesondere auch im Gemisch mit anderen Oligomeren difunktioneller aliphatischer Isocyanate) basierend auf aliphatischer Diaminen oder Polyaminen und aliphatischen Diisocyanaten, insbesondere HDI und TMDI, in Verbindung mit Urethanen aus HDI oder TMDI auf Basis von Additionsprodukten von Butyrolacton, ε-Caprolacton und/oder Methyl-ε-caprolacton (insbesondere ε-Caprolacton) an 2 bis 20 Kohlenstoffatome enthaltende aliphatische, araliphatische oder cycloaliphatische di-, tri- oder polyfunktionelle Alkohole (insbesondere an difunktionelle aliphatische Alkohole mit 3 bis 12 Kohlenstoffatomen) mit zahlenmittleren Molmassen von 200 bis 3000 g/Mol, insbesondere bevorzugt von 1000 bis 2000 g/Mol (insbesondere im Gemisch mit anderen Oligomeren difunktioneller aliphatischer Isocyanate) oder in Verbindung mit Isocyanuraten, Iminooxadiazindionen und/oder anderen Oligomeren basierend auf HDI.

Als Komponente e) werden ein oder mehrere Photoinitiatoren eingesetzt. Dies sind üblicherweise durch aktinische Strahlung aktivierbare Initiatoren, die eine Polymerisation der entsprechenden polymerisierbaren Gruppen auslösen. Photoinitiatoren sind an sich bekannte, kommerziell vertriebene Verbindungen, wobei zwischen unimolekularen (Typ I) und bimolekularen (Typ II) Initiatoren unterschieden wird. Desweiteren werden diese Initiatoren je nach chemischer Natur für die radikalische, die anionische (oder), die kationische (oder gemischte) Formen der vorgenannten Polymerisationen eingesetzt.

(Typ I)-Systeme für die radikalische Photopolymerisation sind z.B. aromatische Ketonverbindungen, z.B. Benzophenone in Kombination mit tertiären Aminen, Alkylbenzophenone, 4,4'-Bis(dimethylamino)benzophenon (Michlers Keton), Anthron und halogenierte Benzophenone oder Mischungen der genannten Typen. Weiter geeignet sind (Typ II)-Initiatoren wie Benzoin und seine Derivate, Benzilketale, Acylphosphinoxide z.B. 2,4,6-Trimethyl-benzoyl-diphenylphosphinoxid, Bisacylophosphinoxide, Phenylglyoxylsäureester, Campherchinon, alpha-Aminoalkylphenone, alpha-,alpha-Dialkoxyacetophenone, 1-[4-(Phenylthio)phenyl]octan-1,2-dion-2-(O-benzoyloxim), unterschiedlich substituierte Hexarylbisimidazole (HABI) mit geeigneten Coinitiatoren wie z.B. Mercaptobenzoxazol sowie alpha-Hydroxyalkylphenone. Auch die in EP-A 0223587 beschriebenen Photoinitiatorsysteme bestehend aus einer Mischung aus einem Ammoniumarylborat und einem oder mehreren Farbstoffen können als Photoinitiator eingesetzt werden. Als Ammoniumarylborat eignen sich beispielsweise Tetrabutylammonium Triphenylhexylborat, Tetrabutylammonium Triphenylbutylborat, Tetrabutylammonium Trinapthylbutylborat, Tetramethylammonium Triphenylbenzylborat, Tetra(n-hexyl)ammonium (sec-Butyl)triphenylborat, 1-Methyl-3-octylimidazolium Dipentyldiphenylborat, Tetrabutylammonium Tris-(4-tert.-butyl)-phenylbutylborat, Tetrabutylammonium Tris-(3-fluorphenyl)-hexylborat und Tetrabutylammonium Tris-(3-Chlor-4-methylphenyl)-hexylborat. Als Farbstoffe eignen sich beispielsweise Neu-Methylenblau, Thionin, Basic Yellow,

Pinacynol Chlorid, Rhodamin 6G, Gallocyanin, Ethylviolett, Victoria Blue R, Celestine Blue, Ghinaldinrot, Kristallviolett, Brilliant Grün, Astrazon Orange G, Darrow Red, Pyronin Y, Basic Red 29, Pyrillium I, Safranin O, Cyanin und Methylenblau, Azur A (Cunningham et al., RadTech'98 North America UV/EB Conference Proceedings, Chicago, Apr. 19-22, 1998).

Die für die anionische Polymerisation verwendeten Photoinitiatoren sind in der Regel (Typ I)-Systeme und leiten sich von Übergangsmetall-Komplexen der ersten Reihe ab. Hier sind ChromSalze, wie z.B. trans-$Cr(NH_3)_2(NCS)_4$-(Kutal et al, Macromolecules 1991, 24, 6872) oder Ferrocenyl-Verbindungen (Yamaguchi et al. Macromolecules 2000, 33, 1152). Eine weitere Möglichkeit der anionischen Polymerisation besteht in der Verwendung von Farbstoffen, wie Kristallviolett Leukonitril oder Malchit Grün Leukonitril, die durch photolytischen Zerfall Cyanoacrylate polymerisieren können (Neckers et al. Macromolecules 2000, 33, 7761). Allerdings wird dabei das Chromophor in das Polymer eingebaut, so dass die resultierenden Polymere durchgefärbt sind.

Die für die kationische Polymerisation verwendeten Photoinitiatoren bestehen im wesentlichen aus drei Klassen: Aryldiazonium-Salze, Onium-Salze (hier speziell: Iodonium-, Sulfonium- und Selenonium-Salze) sowie Organometall-Verbindungen. Phenyldiazonium-Salze können unter Bestrahlung sowohl in Gegenwart als auch in Abwesenheit eines Wasserstoff-Donors ein Kation erzeugten, dass die Polymerisation initiiert. Die Effizienz des Gesamtsystems wird durch die Natur des verwendeten Gegenions zur Diazonium-Verbindung bestimmt. Bevorzugt sind hier die wenig reaktiven aber recht teuren SbF6-, AsF6- oder PF6-. Für den Einsatz in Beschichtung dünner Filme sind diese Verbindungen i.d.R wenig geeignet, da die den nach der Belichtung freigesetzten Stickstoff die Oberflächegüte herabgesetzt wird (pinholes) (Li et al., Polymeric Materials Science and Engineering, 2001, 84, 139). Sehr weit verbreitet und auch in vielerlei Form kommerziell erhältlich sind Onium-Salze, speziell Sulfonium- und Iodonium-Salze. Die Photochemie dieser Verbindungen ist nachhaltig untersucht worden. Die Iodonium-Salze zerfallen nach der Anregung zunächst homolytisch und erzeugen somit ein Radikal und ein Radikalanion, welches sich durch H-Abstraktion stabilisiert und ein Proton freisetzt und dann die kationische Polymerisation startet (Dektar et al. J. Org. Chem. 1990, 55, 639; J. Org. Chem., 1991, 56. 1838). Dieser Mechanimus ermöglicht den Einsatz von Iodoniuin-Salzen ebenfalls für die radikalische Photopolymerisation. Hierbei kommt erneut der Wahl des Gegenions eine große Bedeutung zu, bevorzugt werden ebenfalls $SbF_6^-$, $AsF_6^-$ oder $PF_6^-$. Ansonsten in dieser Strukturklasse die Wahl der Substitution des Aromaten recht frei und im wesentlichen durch die Verfügbarkeit geeigneter Startbausteine für die Synthese bestimmt. Bei den Sulfonium-Salzen handelt es sich um Verbindungen, die in nach Norrish(II) zerfallen (Crivello et al., Macromolecules, 2000, 33, 825). Auch bei den Sulfonium-Salzen kommt der Wahl des Gegenions eine kritische Bedeutung zu, die sich im Wesentlichen in der Härtungsgeschwindigkeit der Polymere äußert. Die besten Ergebnisse werden i.d.R. mit $SbF_6$-Salzen erzielt. Da die Eigenabsorption von Iodonium- und Sulfonium-Salze bei <300nm liegt, müssen diese Verbindungen für die Photopolymerisation mit nahem UV oder kurzwelligem sichtbarem Licht entsprechend sensibilisiert werden. Dies gelingt durch die Verwendung von höher absorbierenden Aromaten wie z.B. Anthracen und Derivaten (Gu et al., Am. Chem. Soc. Polymer Preprints, 2000, 41 (2), 1266) oder Phenothiazin bzw. dessen Derivate (Hua et al, Macromolecules 2001, 34, 2488-2494).

Es kann vorteilhaft sein auch Gemische dieser Verbindungen einzusetzen. Je nach zur Härtung verwendeter Strahlungsquelle muss Typ und Konzentration an Photoinitiator in dem Fachmann bekannter Weise angepasst werden. Näheres ist zum Beispiel in P. K. T. Oldring (Ed.), Chemistry & Technology of UV & EB Formulations For Coatings, Inks & Paints, Vol. 3, 1991, SITA Technology, London, S. 61 - 328 beschrieben.

Bevorzugte Photoinitiatoren e) sind Mischungen aus Tetrabutylammonium Triphenylhexylborat, Tetrabutylammonium Triphenylbutylborat, Tetrabutylammonium Trinapthylbutylborat, Tetrabutylammonium Tris-(4-tert.-butyl)-phenylbutylborat, Tetrabutylammonium Tris-(3-fluorphenyl)-hexylborat und Tetrabutylammonium Tris-(3-Chlor-4-methylphenyl)-hexylborat mit Farbstoffen wie beispielsweise Astrazon Orange G, Methylenblau, Neu Methylenblau, Azur A, Pyrillium I, Safranin O, Cyanin, Gallocyanin, Brilliant Grün, Kristallviolett, Ethylviolett und Thionin.

Das verwendete Photoinitiatorsystem kann vorzugsweise einen anionischen, kationischen oder neutralen Farbstoff und einen Coinitiator umfassen.

Weitere Bestandteile der Photopolymer-Formulierung können sein: d) Radikalstabilisatoren, f) gegenenfalls Katalysatoren oder g) andere Hilfs- und Zusatzstoffe.

Als Beispiele für Radikalstabilisatoren sind Inhibitoren und Antioxidantien wie sie z.B. in "Methoden der organischen Chemie" (Houben-Weyl), 4. Auflage, Band XIV/1, S. 433ff, Georg Thieme Verlag, Stuttgart 1961, beschrieben sind, geeignet. Geeignete Stoffklassen sind beispielsweise Phenole wie z.B. 2,6-Di-tert-butyl-4-methylphenol, Kresole, Hydrochinone, Benzylalkohole wie z.B. Benzhydrol, ggf. auch Chinone wie z. B. 2,5-Di-*tert.*-Butylchinon, ggf. auch aromatische Amine wie Diisopropylamin oder Phenothiazin.

Bevorzugt sind 2,6-Di-*tert.*-butyl-4-methylphenol, Phenothiazin, p-Methyoxyphenol, 2-Methoxy-p-hydrochinon und Benzhydrol.

Gegebenenfalls können ein oder mehrere Katalysatoren eingesetzt werden. Dabei handelt es sich um Katalysatoren zur Beschleunigung der Urethanbildung. Bekannte Katalysatoren hierfür sind beispielsweise Zinnoctoat, Zinkoktoat, Dibutylzinndilaurat, Dimethylbis[(1-oxoneodecyl)oxy]stannan, Dimethylzinndicarboxylat, Zirkonium-bis (ethylhexanoat), Zirconiumacteylacetonat oder tertiäre Aminen wie beispielsweise 1,4-Diazabicyclo[2.2.2]octan, Diazabicyclononan, Diazabicycloundecan, 1,1,3,3-Tetramethylguanidin, 1,3,4,6,7,8-Hexahydro-1-methyl-2H-pyrimido(1,2-a)pyrimidin.

Bevorzugt sind Dibutylzinndilaurat, Dimethylbis[(1-oxoneodecyl)oxy]stannan, Dimethylzinndicarboxylat, 1,4-Diazabicyclo[2.2.2]octan, Diazabicyclononan, Diazabicycloundecan, 1,1,3,3-Tetramethylguanidin, 1,3,4,6,7,8-Hexahydro-1-methyl-2H-pyrimido(1,2-a)pyrimidin.

Selbstverständlich können gegebenenfalls weitere Hilfs- oder Zusatzstoffe eingesetzt werden. Dabei kann es sich beispielsweise um im Bereich der Lacktechnologie gängige Zusatzstoffe wie Lösemittel, Weichmacher, Verlaufsmittel oder Haftvermittler handeln. Es kann auch von Vorteil sein, gleichzeitig mehrere Zusatzstoffe eines Typs zu verwenden. Selbstverständlich kann es ebenfalls von Vorteil sein, mehrere Zusatzstoffe mehrerer Typen zu verwenden.

Die Photopolymer-Formulierung kann zusätzlich Urethane als Weichmacher enthalten, wobei die Urethane bevorzugt mit wenigstens einem Fluoratom substituiert sein können.

Bei den Urethanen handelt es sich vorzugsweise um Verbindungen, die ein Strukturelement der allgemeinen Formel III aufweisen.

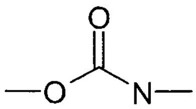

Formel III

Sie können aus monofunktionellen Alkoholen und monofunktionellen Isocyanaten wie oben beschrieben erhalten werden. Bevorzugt sind diese mit wenigstens einem Fluoratom substituiert.

Weiter bevorzugt ist, wenn die Fluorurethane die allgemeine Formel IV

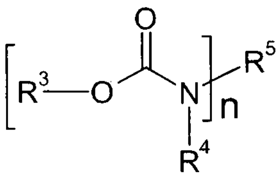

Formel IV

aufweisen, in der n≥1 und n≤8 ist und $R^3$, $R^4$, $R^5$ Wasserstoff und / oder unabhängig voneinander lineare, verzweigte, cyclische oder heterocyclische unsubstituierte oder gegebenenfalls auch mit Heteroatomen substituierte organische Reste sind, wobei mindestens einer der Reste $R^3$, $R^4$, $R^5$ mit wenigstens einem Fluoratom substituiert ist. Besonders bevorzugt ist hierbei $R^3$ ein organischer Rest mit mindestens einem Fluoratom.

Gemäß einer weiteren Ausführungsform kann $R^3$ 1-20 $CF_2$ Gruppen und / oder eine oder mehrere $CF_3$ Gruppen, besonders bevorzugt 1-15 $CF_2$ Gruppen und / oder eine oder mehrere $CF_3$ Gruppen, insbesondere bevorzugt 1-10 $CF_2$ Gruppen und / oder eine oder mehrere $CF_3$ Gruppen, ganz besonders bevorzugt 1-8 $CF_2$ Gruppen und / oder eine oder mehrere $CF_3$ Gruppen, $R^4$ einen C1-C20 Alkyl-Rest, bevorzugt einen C1-C15 Alkyl-Rest besonders bevorzugt einen C1-C10 Alkyl-Rest oder Wasserstoff, und / oder $R^5$ einen C1-C20 Alkyl-Rest, bevorzugt einen C1-C15 Alkyl-Rest besonders bevorzugt einen C1-C10 Alkyl-Rest oder Wasserstoff umfassen.

Die Fluorurethane können einen Fluorgehalt von 10-80 Gew.-% Fluor, bevorzugt von 13-70 Gew.-% Fluor und besonders bevorzugt 17,5-65 Gew.-% Fluor aufweisen.

Gemäß einer weiteren bevorzugten Ausführungsform der Erfindung ist vorgesehen, dass die Photopolymer-Formulierung 10 bis 89,999 Gew.-%, bevorzugt 25 bis 70 Gew.-% Matrixpolymere, 10 bis 60 Gew.-%, bevorzugt 25 bis 50 Gew.-% Schreibmonomere, 0,001 bis 5 Gew.-% Photoinitiatoren und gegebenenfalls 0 bis 4 Gew.-%, bevorzugt 0 bis 2 Gew.-% Katalysatoren, 0 bis 5 Gew.-% , bevorzugt 0,001 bis 1 Gew.-% Radikalstabilisatoren 0 bis 30 Gew.-%, bevorzugt 0 bis 25 Gew.-% Weichmacher und 0 bis 5 Gew.-%, bevorzugt 0,1 bis 5 Gew.-% weitere Additive enthält, wobei die Summe aller Bestandteile 100 Gew.-% beträgt.

Besonders bevorzugt werden Photopolymer-Formulierungen mit 25 bis 70 Gew.-% Matrixpolymeren bestehend aus Verbindungen der Komponente a) und der Komponente b), 25 bis 50 Gew.-% Schreibmonomere, 0,001 bis 5 Gew.-% Photoinitiatoren, 0 bis 2 Gew.-% Katalysatoren, 0,001 bis 1 Gew.-% Radikalstabilisatoren gegebenenfalls 0 bis 25 Gew.-% der oben beschriebenen Urethane und gegebenenfalls 0,1 bis 5 Gew.-% weiterer Additive eingesetzt.

Ein zweiter Aspekt der Erfindung betrifft die Verwendung einer erfindungsgemäßen Photopolymer-Formulierung zur Herstellung von optischen Elementen, insbesondere zur Herstellung von holgraphischen Elementen und Bildern. Die holgraphischen Elemente können beispielsweise die Funktion einer optischen Linse, eines Spiegels, eines Umlenkspiegels, eines Filters, einer Streuscheibe, eines Beugungselements, eines Lichtleiters, eines Lichtlenkers, einer Projektionsscheibe und/oder einer Maske haben. Zudem können auch holographische Bilder oder Darstellungen zum Beispiel für persönliche Portraits, biometrische Darstellungen in Sicherheitsdokumenten, oder allgemein von Bilder oder Bildstrukturen für Werbung, Sicherheitslabels, Markenschutz, Markenbranding, Etiketten, Designelementen, Dekorationen, Illustrationen, Sammelkarten, Bilder und dergleichen sowie Bilder, die digitale Daten repräsentieren können, u.a auch in Kombination mit den zuvor dargestellten Produkten hergestellt werden. Aus der erfindungsgemäßen Photopolymer-Formulierung kann auch eine Folie, eine Film, eine Schicht, eine Schichtaufbau oder eine Formkörper hergestellt werden.

Ein dritter Aspekt der Erfindung ist ein Verfahren zur Herstellung einer erfindungsgemäßen Photopolymer-Formulierung, bei dem Matrixpolymere, Schreibmonomere, Photoinitiatoren, gegebenenfalls Weichmacher und gegebenenfalls weitere Additive zu der Photopolymer-Formulierung vermischt werden.

Ein weiterer Gegenstand der vorliegenden Erfindung ist daher auch ein Verfahren zur Herstellung von Medien zur Aufzeichnung visueller Hologramme, bei dem solche Photopolymer-Formulierung en auf ein Substrat oder in eine Form appliziert und ausgehärtet werden. Ebenfalls ein Gegenstand der Erfindung sind die so erhältlichen Medien.

Das erfindungsgemäße Verfahren wird bevorzugt derart durchgeführt, dass die Aufbaukomponenten der erfindungsgemäßen Polyurethanzusammensetzungen mit Ausnahme der Komponente a) miteinander homogen vermischt werden und unmittelbar vor der Applikation auf das Substrat oder in die Form erst Komponente a) zugemischt wird.

Zur Vermischung können alle dem Fachmann aus der Mischungstechnik an sich bekannten Verfahren und Apparate, wie beispielsweise Rührkessel oder sowohl dynamische als auch statische Mischer verwendet werden. Bevorzugt sind allerdings Apparate ohne oder mit nur geringen Toträumen. Weiterhin sind Verfahren bevorzugt, in denen die Vermischung innerhalb sehr kurzer Zeit und mit sehr starker Durchmischung der beiden zu mischenden Komponenten erfolgt. Hierfür eignen sich insbesondere dynamische Mischer, insbesondere solche, in denen die Komponenten erst im Mischer miteinander in Kontakt kommen.

Die Temperaturen betragen dabei 0 bis 100°C, bevorzugt 10 bis 80 °C, besonders bevorzugt 20 bis 60 °C.

Falls notwendig kann auch eine Entgasung der einzelnen Komponenten oder der gesamten Mischung unter einem reduzierten Druck von beispielsweise 1 mbar durchgeführt werden. Ein Entgasen, insbesondere nach Zugabe der Komponente a) ist bevorzugt, um Blasenbildung durch Restgase in den erhältlichen Medien zu verhindern.

Vor Zumischung der Komponente a) können die Mischungen als lagerstabiles Zwischenprodukt gegebenenfalls über mehrere Monate gelagert werden kann.

Nach der Zumischung der Komponente a) der erfindungsgemäßen Polyurethanzusammensetzungen wird eine flüssige Formulierung erhalten, die je nach Zusammensetzung bei Raumtemperatur innerhalb weniger Sekunden bis zu einigen Stunden aushärtet.

Das Verhältnis sowie die Art und Reaktivität der Aufbaukomponenten der Polyurethanzusammensetzungen wird bevorzugt so eingestellt, dass die Aushärtung nach Zumischung der Komponente a) bei Raumtemperatur innerhalb von Minuten bis zu 16 Stunden eintritt.

Die vorgenannte Einstellung hinsichtlich des Aushärteverhaltens ist für einen Fachmann leicht in Form von Routineversuchen innerhalb der oben angegebenen Mengenbereich der Komponenten sowie der jeweils zur Auswahl stehenden, insbesondere den bevorzugten Aufbaukomponenten, leicht möglich.

Die erfindungsgemäßen Polyurethanzusammensetzungen besitzen unmittelbar nach vollständiger Vermischung aller Komponenten Viskositäten bei 25°C von typischerweise 10 bis 100000 mPas, bevorzugt 100 bis 20000 mPas, besonders bevorzugt 200 bis 10000 mPas, insbesondere bevorzugt 500 bis 5000 mPas so dass sie bereits in lösemittelfreier Form sehr gute verarbeitungstechnische Eigenschaften besitzen. In Lösung mit geeigneten Lösemitteln können Viskositäten bei 25°C unterhalb 10000 mPas, bevorzugt unterhalb 2000 mPas, besonders bevorzugt unterhalb 500 mPas eingestellt werden.

Als vorteilhaft haben sich Polyurethanzusammensetzungen der vorstehend genannten Art erwiesen, die in einer Menge von 15 g und mit einem Katalysatorgehalt zwischen 0,005 Gew.-% und 0,1 Gew.-% bei 25°C unter 4 Stunden aushärten.

Zur Applikation auf ein Substrat bzw. in eine Form sind alle jeweiligen gängigen, dem Fachmann bekannten Verfahren geeignet, wie insbesondere Rakeln, Gießen, Drucken, Siebdruck, Spritzen, oder Inkjet-Druck.

Ein vierter Aspekt der Erfindung ist ein Verfahren zur Belichtung von holographischen Medien aus einer erfindungsgemäßen Photopolymer-Formulierung, bei dem die Schreibmonomere durch elektromagnetische Strahlung selektiv polymerisiert werden.

## Beispiele:

Die folgenden Beispiele dienen zur Erläuterung der Erfindung. Sofern nicht abweichend vermerkt beziehen sich alle Prozentangaben auf Gewichtsprozent.

Einsatzstoffe:

Isocyanatkomponente 1 ist ein Versuchsprodukt der Bayer MaterialScience AG, Leverkusen, Deutschland, Hexandiisocyanat-basiertes Polyisocyanat, Anteil an Iminooxadiazindion mindestens 30 %, NCO-Gehalt: 23,5 %.

Isocyanatkomponente 2 ist ein Versuchsprodukt der Bayer MaterialScience AG, Leverkusen, Deutschland, Vollallophanat von Hexandiisocyanat auf Polypropylenglykol mit zahlemnittlerer Mohnasse von 4000 g/mol, NCO-Gehalt: 5,6 - 6,4 %.

Isocyanatkomponente 3 ist ein Versuchsprodukt der Bayer MaterialScience AG, Leverkusen, Deutschland, aliphatisches Polyisocyanat auf Basis von Hexandiisocyanat, NCO-Gehalt ca. 20 %.

Isocyanatkomponente 4 ist ein Versuchsprodukt der Bayer MaterialScience AG, Leverkusen, Deutschland, Vollallophanat von Hexandiisocyanat auf Polypropylenglykol mit zahlenmittlerer Molmasse von ca. 280 g/mol, NCO-Gehalt: 16,5 - 17,3 %.

Isocyanatkomponente 5 ist ein Handelsprodukt der Bayer MaterialScience AG, Leverkusen, Deutschland, Mischung aus 29,4 mol-% Isocyanurats auf Basis von HDI mit 70,6 mol-% des Urethans aus Poly(ε-Caprolacton) der zahlenmittleren Molmasse 650 g/Mol mit HDI, NCO-Gehalt 10,5 - 11,5 %.

Isocyanatkomponente 6 ist ein Handelsprodukt der Bayer MaterialScience AG, Leverkusen, Deutschland, aliphatisches Biuret-Typ auf Basis Hexamethylendiisocyanat, NCO-Gehalt: 22,5 - 23,5 %.

Polyol 1 ist ein experimentelles Produkt der Bayer MaterialScience AG, Leverkusen, Deutschland, die Herstellung ist unten beschrieben.

Polyol 2 ist ein Handelsprodukt der Bayer MaterialScience AG, Leverkusen, Deutschland, Polypropylenoxid der zahlenmittleren Molmasse 4000 g/Mol.

Polyol 3 ist ein experimentelles Produkt der Bayer MaterialScience AG, Leverkusen, Deutschland, die Herstellung ist unten beschrieben.

Polyol 4 ist ein experimentelles Produkt der Bayer MaterialScience AG, Leverkusen, Deutschland, die Herstellung ist unten beschrieben.

Polyol 5 ist ein experimentelles Produkt der Bayer MaterialScience AG, Leverkusen, Deutschland, die Herstellung ist unten beschrieben.

Polyol 6 ist ein experimentelles Produkt der Bayer MaterialScience AG, Leverkusen, Deutschland, die Herstellung ist unten beschrieben.

Polyol 7 ist ein experimentelles Produkt der Bayer MaterialScience AG, Leverkusen, Deutschland, die Herstellung ist unten beschrieben.

Polyol 8 ist ein experimentelles Produkt der Bayer MaterialScience AG, Leverkusen, Deutschland, die Herstellung ist unten beschrieben.

Polyol 9 ist ein experimentelles Produkt der Bayer MaterialScience AG, Leverkusen, Deutschland, die Herstellung ist unten beschrieben.

Polyol 10 ist ein Handelsprodukt der Bayer MaterialScience AG, Leverkusen, Deutschland, Polyester auf Basis Adipinsäure, Hexandiol, Neopentylgloykol der zahlenmittleren Molmasse 2000 g/Mol.

DMC-Katalysator: Doppelmetallcyanid-Katalysator auf Basis Zinkhexacyanocobaltat (III), erhältlich nach dem in EP-A 700 949 beschriebenen Verfahren.

Irganox 1076 ist Octadecyl 3,5-di-(tert)-butyl-4-hydroxyhydrocinnamate (CAS 2082-79-3).

Acrylat 1 ist Bisphenol A ethoxylate (1.5 EO/phenol)-diacrylate und wurde von SIGMA-ALDRICH CHEMIE GmbH, Steinheim, Deutschland bezogen. $n_D^{20}$: 1,570.

Acrylat 2 ist Phenylthioethyl-acrylat und wurde von der Bimax, Cockeysville, Maryland, USA bezogen. $n_D^{20}$: 1,603.

Acrylat 3 ist ein experimentelles Produkt der Bayer MaterialScience AG, Leverkusen, Deutschland, die Herstellung ist unten beschrieben.

Acrylat 4 ist ein experimentelles Produkt der Bayer MaterialScience AG, Leverkusen, Deutschland, die Herstellung ist unten beschrieben.

Acrylat 5 ist ein experimentelles Produkt der Bayer MaterialScience AG, Leverkusen, Deutschland, die Herstellung ist unten beschrieben.

Acrylat 6 ist ein experimentelles Produkt der Bayer MaterialScience AG, Leverkusen, Deutschland, die Herstellung ist unten beschrieben.

Acrylat 7 ist ein experimentelles Produkt der Bayer MaterialScience AG, Leverkusen, Deutschland, die Herstellung ist unten beschrieben.

Katalysator 1: Urethanisierungskatalysator, Dimethylbis[(1-oxoneodecl)oxy]stannan, Handelsprodukt der Momentive Performance Chemicals, Wilton, CT, USA (als 10%ige Lösung in N-Ethylpyrrolidon eingesetzt).

Coinitiator 1: Tetrabutylammonium-tris(3-chlor-4-methylphenyl)(hexyl)borat, [1147315-11-4]) ist ein von der Ciba Inc., Basel, Schweiz, hergestelltes Versuchsprodukt.

Coinitiator 2 besteht aus 66,7 Gew.-% Tetrabutylammonium-triphenyl-butyl-borat [12307-06-4] (bezogen von Showa-Denko, Fine Chemicals Group, Specialty Chemicals Department, Chemicals Division, SHOWA DENKO K.K., Japan) und 33,3 Gew.-% 2-Mercaptobenzimidazol (CAS-Nr. 583-39-1, bezogen von ABCR GmbH, Karlsruhe, Deutschland).

Farbstoff 1 ist Neu Methylenblau (CAS 1934-16-3) und wurde von SIGMA-ALDRICH CHEMIE GmbH, Steinheim, Deutschland bezogen.

Farbstoff 2 ist Safranin O (CAS 477-73-6) und wurde von SIGMA-ALDRICH CHEMIE GmbH, Steinheim, Deutschland bezogen.

Farbstoff 3 ist Ethylviolett (CAS 2390-59-2) und wurde in 80%-iger Reinheit von SIGMA-ALDRICH CHEMIE GmbH, Steinheim, Deutschland bezogen und so eingesetzt.

Die Additive 1 bis 37 sind experimentelle Produkte der Bayer MaterialScience AG, Leverkusen, Deutschland, deren Herstellung ist unten beschrieben.

<u>Messmethoden:</u>

Die angegebenen OH-Zahlen wurden gemäß DIN 53240-2 bestimmt.

Die angegebenen NCO-Werte (Isocyanat-Gehalte) wurden gemäß DIN EN ISO 11909 bestimmt.

Die angegebenen Viskositäten wurden auf folgende Weise bestimmt:

Für die Bestimmung der Viskosität wurde die zu untersuchende Komponente oder Mischung bei 20°C in einem Kegel Platte Messsystem eines Rheometers (Firma Anton Paar Physica Modell MCR 51) aufgetragen. Die Messung wird bei folgenden Bedingungen durchgeführt:

- Messkörper: Kegel CP 25, d = 25mm, Winkel = 1°
- Messspalt als Abstand zwischen Kegel und Platte: 0,047 mm
- Messdauer: 10 sec.
- Bestimmung der Viskosität bei einer Scherrate von 250 1/sec.

Messung der Brechungsindizes der photopolymerisierbaren Schreibmonomere c)

Der Brechungsindex n in Abhängigkeit von der Wellenlänge der Proben wurden aus den Transmissions- und Reflexionsspektren erhalten. Dazu wurden ca. 100 - 300 nm dicke Filme der Proben auf Quarzglasträger aus verdünnter Lösung in Butylacetat aufgeschleudert. Das Transmissions- und Reflexionsspektrum dieses Schichtpaketes wurde mit einem Spektrometer der Firma STEAG ETA-Optik, CD-Measurement System ETA-RT gemessen und danach die Schichtdicke und der spektrale Verlauf von n an die gemessenen Transmissions- und Reflexionsspektren im Bereich von 380 - 850 nm angepasst. Dies geschieht mit der internen Software des Spektrometers und erfordert zusätzlich die Brechungsindexdaten des Quarzglassubstrates, die in einer Blindmessung vorab bestimmt wurden. Die Brechungsindizes für die photopolymerisierbaren Monomere c) beziehen sich auf die Wellenlänge von 405 nm und entsprechen damit $n_D^{20}$.

Messung der holographischen Eigenschaften DE und $\Delta n$ der holographischen Medien mittels Zweistrahlinterferenz in Reflexionsanordnung.

Die wie unten beschrieben hergestellten holographischen Medien wurden anschließend mittels einer Messanordnung gemäß Figur 1 wie folgt auf ihre holographischen Eigenschaften geprüft:

Der Strahl eines He-Ne Lasers (Emissionswellenlänge 633 nm) wurde mit Hilfe des Raumfilter (SF) und zusammen mit der Kollimationslinse (CL) in einen parallelen homogenen Strahl umgewandelt. Die finalen Querschnitte des Signal und Referenzstrahls werden durch die Irisblenden (I) festgelegt. Der Durchmesser der Irisblendenöffnung beträgt 0.4 cm. Die polarisationsabhängigen Strahlteiler (PBS) teilen den Laserstrahl in zwei kohärente gleich polarisierte Strahlen. Über die $\lambda/2$ Plättchen wurden die Leistung des Referenzstrahls auf 0.5 mW und die Leistung des Signalstrahls auf 0.65 mW eingestellt. Die Leistungen wurden mit den Halbleiterdetektoren (D) bei ausgebauter Probe bestimmt. Der Einfallswinkel ($\alpha_0$) des Referenzstrahls beträgt -21.8°, der Einfallswinkel. ($\beta_0$) des Signalstrahls beträgt 41.8°. Die Winkel werden ausgehend von der Probennormale zur Strahlrichtung gemessen. Gemäß Figur 1 hat daher $\alpha_0$ ein negatives Vorzeichen und $\beta_0$ ein positives Vorzeichen. Am Ort der Probe (Medium) erzeugte das Interferenzfeld der zwei überlappenden Strahlen ein Gitter heller und dunkler Streifen die senkrecht zur Winkelhalbierenden der zwei auf die Probe einfallenden Strahlen liegen (Reflexionshologramm). Der Streifenabstand A, auch Gitterperiode genannt, im Medium beträgt ~ 225 nm (der Brechungsindex des Mediums zu ~1.504 angenommen).

Figur 1 zeigt die Geometrie eines Holographic Media Testers (HMT) bei $\lambda$ = 633 nm (He-Ne Laser): M = Spiegel, S = Verschluss, SF = Raumfilter, CL = Kollimatorlinse, $\lambda/2$ = $\lambda/2$ Platte, PBS = polarisationsempfindlicher Strahlteiler, D = Detektor, I = Irisblende, $\alpha_0$ = -21.8°, $\beta_0$ = 41.8° sind die Einfallswinkel der kohärenten Strahlen außerhalb der Probe (des Mediums) gemessen. RD = Referenzrichtung des Drehtisches.

Es wurden auf folgende Weise Hologramme in das Medium geschrieben:

- Beide Shutter (S) sind für die Belichtungszeit t geöffnet.
- Danach wurde bei geschlossenen Shuttem (S) dem Medium 5 Minuten Zeit für die Diffusion der noch nicht polymerisierten Schreibmonomere gelassen.

Die geschriebenen Hologramme wurden nun auf folgende Weise ausgelesen. Der Shutter des Signalstrahls blieb geschlossen. Der Shutter des Referenzstrahls war geöffnet. Die Irisblende des Referenzstrahls wurde auf einen Durchmesser < 1 mm geschlossen. Damit erreichte man, dass für alle Drehwinkel ($\Omega$) des Mediums der Strahl immer vollständig im zuvor geschriebenen Hologramm lag. Der Drehtisch überstrich nun computergesteuert den Winkelbereich von $\Omega_{min}$ bis $\Omega_{max}$ mit einer Winkelschrittweite von 0.05°. $\Omega$ wird von der Probennormale zur Referenzrichtung des Drehtisches gemessen. Die Referenzrichtung des Drehtisches ergibt sich dann wenn beim Schreiben des Hologramms der Einfallswinkel des Referenz- und des Signalstrahls betragsmäßig gleich sind also $\alpha_0$ = -31.8° und $\beta_0$=31.8° gilt. Dann beträgt $\Omega_{recording}$ = 0°. Für $\alpha_0$= -21.8° und $\beta_0$ = 41.8° beträgt $\Omega_{recording}$ daher 10°. Allgemein gilt für das Interferenzfeld beim Schreiben ("recording") des Hologramms:

$$\alpha_0 = \theta_0 + \Omega_{recording}.$$

$\theta_0$ ist der Halbwinkel im Laborsystem außerhalb des Mediums und es gilt beim Schreiben des Hologramms:

$$\theta_0 = \frac{\alpha_0 - \beta_0}{2}.$$

In diesem Fall gilt also $\theta_0$ = -31.8°. An jedem angefahrenen Drehwinkel $\Omega$ wurden die Leistungen des in der nullten Ordnung transmittierten Strahls mittels des entsprechenden Detektors D und die Leistungen des in die erste Ordnung abgebeugten Strahls mittels des Detektors D gemessen. Die Beugungseffizienz ergab sich bei jedem angefahrenen Winkel $\Omega$ als der Quotient aus:

$$\eta = \frac{P_D}{P_D + P_T}$$

$P_D$ ist die Leistung im Detektor des abgebeugten Strahls und $P_T$ ist die Leistung im Detektor des transmittierten Strahls.

Mittels des oben beschriebenen Verfahrens wurde die Braggkurve, sie beschreibt den Beugungswirkungsgrad $\eta$ in Abhängigkeit des Drehwinkels $\Omega$ des geschriebenen Hologramms gemessen und in einem Computer gespeichert. Zusätzlich wurde auch die in die nullte Ordnung transmittierte Intensität gegen den Drehwinkel $\Omega$ aufgezeichnet und in einem Computer gespeichert.

Die maximale Beugungseffzienz (DE = $\eta_{max}$) des Hologramms, also sein Spitzenwert, wurde bei $\Omega_{reconstruction}$ ennittelt. Eventuell musste dazu die Position des Detektors des abgebeugten Strahls verändert werden, um diesen maximalen Wert zu bestimmen.

Der Brechungsindexkontrast $\Delta$n und die Dicke d der Photopolymerschicht wurde nun mittels der Coupled Wave Theorie (siehe; H. Kogelnik, The Bell System Technical Journal, Volume 48, November 1969, Number 9 Seite 2909 - Seite 2947) an die gemessene Braggkurve und den Winkelverlauf der transmittierten Intensität ermittelt. Dabei ist zu beachten, dass wegen der durch die Photopolymerisation auftretenden Dickenschwindung der Streifenabstand Λ' des Hologramms und die Orientierung der Streifen (slant) vom Streifenabstand Λ des Interferenzmusters und dessen Orientierung abweichen kann. Demnach wird auch der Winkel $\alpha_0$' bzw. der entsprechende Winkel des Drehtisches $\Omega_{reconstruction}$, bei dem maximale Beugungseffizienz erreicht wird von $\alpha_0$ bzw. vom entsprechenden $\Omega_{recording}$ abweichen. Dadurch verändert sich die Bragg-Bedingung. Diese Veränderung wird im Auswerteverfahren berücksichtigt. Das Auswerteverfahren wird im Folgenden beschrieben:

Alle geometrischen Größen, die sich auf das geschriebene Hologramm beziehen und nicht auf das Interferenzmuster werden als gestrichene Größen dargestellt.

Für die Braggkurve $\eta(\Omega)$ eines Reflexionshologramms gilt nach Kogelnik:

$$\eta = \begin{cases} \dfrac{1}{1 - \dfrac{1-(\xi/\nu)^2}{\sin^2\left(\sqrt{\xi^2-\nu^2}\right)}}, \text{für } \nu^2 - \xi^2 < 0 \\ \dfrac{1}{1 + \dfrac{1-(\xi/\nu)^2}{\sinh^2\left(\sqrt{\nu^2-\xi^2}\right)}}, \text{für } \nu^2 - \xi^2 \geq 0 \end{cases}$$

mit:

$$\nu = \frac{\pi \cdot \Delta n \cdot d'}{\lambda \cdot \sqrt{|c_s \cdot c_r|}}$$

$$\xi = -\frac{d'}{2 \cdot c_s} \cdot DP$$

$$c_s = \cos(\vartheta') - \cos(\psi') \cdot \frac{\lambda}{n \cdot \Lambda'}$$

$$c_r = \cos(\vartheta')$$

$$DP = \frac{\pi}{\Lambda'} \cdot \left(2 \cdot \cos(\psi' - \vartheta') - \frac{\lambda}{n \cdot \Lambda'}\right)$$

$$\psi' = \frac{\beta' + \alpha'}{2}$$

$$\Lambda' = \frac{\lambda}{2 \cdot n \cdot \cos(\psi' - \alpha')}$$

Beim Auslesen des Hologramms ("reconstruction") gilt wie analog oben dargestellt:

$$\vartheta'_0 = \theta_0 + \Omega$$
$$\sin(\vartheta'_0) = n \cdot \sin(\vartheta')$$

An der Bragg-Bedingung ist das "Dephasing" DP = 0. Und es folgt entsprechend:

$$\alpha'_0 = \theta_0 + \Omega_{reconstruction}$$
$$\sin(\alpha'_0) = n \cdot \sin(\alpha')$$

Der noch unbekannte Winkel β' kann aus dem Vergleich der Bragg-Bedingung des Interferenzfeldes beim Schreiben des Hologramms und der Bragg-Bedingung beim Auslesen des Hologramms ermittelt werden unter der Annahme, dass nur Dickenschwindung stattfindet. Dann folgt:

$$\sin(\beta') = \frac{1}{n} \cdot [\sin(\alpha_0) + \sin(\beta_0) - \sin(\theta_0 + \Omega_{reconstruction})]$$

v ist die Gitterstärke, $\xi$ ist der Detuning Parameter und $\psi'$ die Orientierung (Slant) des Brechungsindexgitters das geschrieben wurde. $\alpha'$ und $\beta'$ entsprechen den Winkeln $\alpha_0$ und $\beta_0$ des Interferenzfeldes beim Schreiben des Hologramms, aber im Medium gemessen und für das Gitter des Hologramms gültig (nach Dickenschwindung). n ist der mittlere Brechungsindex des Photopolymers und wurde zu 1.504 gesetzt. $\lambda$ ist die Wellenlänge des Laserlichts im Vakuum.

Die maximale Beugungseffizienz (DE = $\eta_{max}$) ergibt sich dann für $\xi$ = 0 zu:

$$DE = \tanh^2(\nu) = \tanh^2\left(\frac{\pi \cdot \Delta n \cdot d'}{\lambda \cdot \sqrt{\cos(\alpha') \cdot \cos(\alpha' - 2\psi)}}\right)$$

Die Messdaten der Beugungseffizienz, die theoretische Braggkurve und die transmittierte Intensität werden wie in Figur 2 gezeigt gegen den zentrierten Drehwinkel $\Delta Q = \Omega_{reconstruction} - \Omega = \alpha'_0 - \vartheta'_0$, auch Winkeldetuning genannt, aufgetragen.

Da DE bekannt ist wird die Form der theoretischen Braggkurve nach Kogelnik nur noch durch die Dicke *d'* der Photopolymerschicht bestimmt. $\Delta$n wird über DE für gegebene Dicke *d'* so nachkorrigiert, dass Messung und Theorie von DE immer übereinstimmen. *d'* wird nun solange angepasst bis die Winkelpositionen der ersten Nebenminima der theoretischen Braggkurve mit den Winkelpositionen der ersten Nebenmaxima der transmittierten Intensität übereinstimmen und zudem die volle Breite bei halber Höhe (FWHM) für die theoretische Braggkurve und für die transmittierte Intensität übereinstimmen.

Da die Richtung in der ein Reflexionshologramm bei der Rekonstruktion mittels eines $\Omega$-Scans mitrotiert, der Detektor für das abgebeugte Licht aber nur einen endlichen Winkelbereich erfassen kann, wird die Braggkurve von breiten Holgrammen (kleines *d'*) bei einem $\Omega$-Scan nicht vollständig erfasst, sondern nur der zentrale Bereich, bei geeigneter Detektorpositionierung. Daher wird die zur Braggkurve komplementäre Form der transmittierten Intensität zur Anpassung der Schichtdicke *d'* zusätzlich herangezogen.

Figur 2 zeigt die gemessene transmittierte Leistung $P_T$ (rechte *y*-Achse) als durchgezogene Linie gegen das Winkeldetuning $\Delta\Omega$ aufgetragen, die gemessene Beugungseffizienz $\eta$ (linke *y*-Achse) als ausgefüllte Kreise gegen das Winkeldetuning $\Delta\Omega$ aufgetragen (soweit die endliche Größe des Detektors es erlaubte) und die Anpassung der Kogelnik Theorie als gestrichelte Linie (linke *y*-Achse).

Für eine Formulierung wurde diese Prozedur eventuell mehrfach für verschiedene Belichtungszeiten t an verschiedenen Medien wiederholt, um festzustellen bei welcher mittleren Energiedosis des einfallenden Laserstrahls beim Schreiben des Hologramms DE in den Sättigungswert übergeht. Die mittlere Energiedosis E ergibt sich wie folgt aus den Leistungen der zwei den Winkeln $\alpha_0$ und $\beta_0$ zugeordneten Teilstrahlen (Referenzstrahl mit $P_r$ = 0.50 mW und Signalstrahl mit $P_s$ = 0.63 mW), der Belichtungszeit t und dem Durchmesser der Irisblende (0.4 cm):

$$E\,(\mathrm{mJ/cm^2}) = \frac{2 \cdot [P_r + P_s] \cdot t\,(\mathrm{s})}{\pi \cdot 0.4^2\ \mathrm{cm}^2}$$

Die Leistungen der Teilstrahlen wurden so angepasst, dass in dem Medium bei den verwendeten Winkeln $\alpha_0$ und $\beta_0$, die gleiche Leistungsdichte erreicht wird.

Als Alternative I wurde auch ein dem in Abbildung 1 dargestellten Aufbau äquivalenter Test mit einem grünen Laser mit der Emissionswellenlänge $\lambda$ im Vakuum von 532 nm durchgeführt. Dabei beträgt $\alpha_0$ = -11.5° und $\beta_0$ = 33.5° und $P_r$ = 1.84 mW und $P_s$ = 2.16 mW.

In Beispielen wird jeweils der maximale Wert in $\Delta$n berichtet, die verwendeten Dosen liegen zwischen 4 und 64 mJ/cm$^2$ pro Arm.

<u>Herstellung von Polyol 1:</u>

In einem 1 L Kolben wurden 0.18 g Zinnoktoat, 374.8 g $\varepsilon$-Caprolacton und 374.8 g eines difunktionellen Polytetrahydrofuranpolyetherpolyols (Equivalentgewicht 500 g/Mol OH) vorgelegt und auf 120 °C aufgeheizt und so lange auf dieser Temperatur gehalten, bis der Festgehalt (Anteil der nicht-flüchtigen Bestandteile) bei 99.5 Gew.-% oder darüber lag. Anschließend wurde abgekühlt und das Produkt als wachsiger Feststoff erhalten.

Herstellung von Polyol 3:

In einen mit Rührwerk ausgestatteten 20 1 - Reaktionskessel wurden 2465 g eines difunktionellen Polytetrahydrofuranpolyetherpolyols (Equivalentgewicht 325 g/Mol OH) eingewogen und 450,5 mg DMC-Katalysator zugegeben. Dann wurde unter Rühren bei ca. 70 U/min. auf 105 °C erhitzt. Durch dreimaliges Anlegen von Vakuum und Entspannen mit Stickstoff wurde Luft gegen Stickstoff ausgetauscht. Nach Erhöhung der Rührerdrehzahl auf 300 U/min.wurde für 72 Minuten bei laufender Vakuumpumpe und einem Druck von etwa 0,1 bar von unten Stickstoff durch die Mischung geleitet. Danach wurden mittels Stickstoff ein Druck von 0,3 bar eingestellt und 242 g Propylenoxid (PO) zum Start der Polymerisation eingeleitet. Hierbei stieg der Druck auf 2,03 bar. Nach 8 Minuten war der Druck wieder auf 0,5 bar abgefallen und es wurden über einen Zeitraum von 2h 11 min. weitere 12,538 kg PO bei 2,34 bar eindosiert. 17 Minuten nach Ende der PO-Dosierung wurde bei einem Restdruck von 1,29 bar Vakuum angelegt und vollständig entgast. Der Produkt wurde durch Zugabe von 7,5 g Irganox 1076 stabilisiert und als farblose, viskose Flüssigkeit erhalten (OH-Zahl: 27,8 mg KOH/g, Viskosität bei 25°C: 1165 mPas).

Herstellung von Polyol 4:

In einen mit Rührwerk ausgestatteten 20 1 - Reaktionskessel wurden 2475 g eines difunktionellen Polytetrahydrofuranpolyetherpolyols (Equivalentgewicht 325 g/Mol OH) eingewogen und 452,6 mg DMC-Katalysator zugegeben. Dann wurde unter Rühren bei ca. 70 U/min. auf 105 °C erhitzt. Durch dreimaliges Anlegen von Vakuum und Entspannen mit Stickstoff wurde Luft gegen Stickstoff ausgetauscht. Nach Erhöhung der Rührerdrehzahl auf 300 U/min. wurde für 57 Minuten bei laufender Vakuumpumpe und einem Druck von etwa 0,1 bar von unten Stickstoff durch die Mischung geleitet. Danach wurden mittels Stickstoff ein Druck von 0,5 bar eingestellt und 100 g Ethylenoxid (EO) und 150 g PO parallel zum Start der Polymerisation eingeleitet. Hierbei stieg der Druck auf 2,07 bar. Nach 10 Minuten war der Druck wieder auf 0,68 bar abgefallen und es wurden über einen Zeitraum von 1h 53 min. weitere 5,116 kg EO und 7,558 kg PO als Gemisch bei 2,34 bar zugeleitet. 31 Minuten nach Ende der Epoxiddosierung wurde bei einem Restdruck von 2,16 bar Vakuum angelegt und vollständig entgast. Der Produkt wurde durch Zugabe von 7,5 g Irganox 1076 stabilisiert und als, leicht trübe, viskose Flüssigkeit erhalten (OH-Zahl 27,1 mg KOH/g, Viskosität bei 25°C: 1636 mPas).

Herstellung von Polyol 5:

In einen mit Rührwerk ausgestatteten 20 1 - Reaktionskessel wurden 1707 g eines Polycarbonatdiols der zahlenmittleren Molmasse 650 g/Mol hergestellt durch Polykondensation von (3-Methyl)-1,5-pentandiol und Diphenylcarbonat, eingewogen und 527 mg DMC-Katalysator zugegeben.. Dann wurde unter Rühren bei ca. 70 U/min. auf 130 °C erhitzt. Durch dreimaliges Anlegen von Vakuum und Entspannen mit Stickstoff wurde Luft gegen Stickstoff ausgetauscht. Nach Erhöhung der Rührerdrehzahl auf 300 U/min. wurde für 85 Minuten bei laufender Vakuumpumpe und einem Druck von etwa 0,1 bar von unten Stickstoff durch die Mischung geleitet. Danach wurden mittels Stickstoff ein Druck von 0,2 bar eingestellt und 174 g PO zum Start der Polymerisation eingeleitet Hierbei stieg der Druck auf 2,26 bar an. Nach 6 Minuten war der Druck wieder auf 0,55 bar abgefallen und es wurden über einen Zeitraum von 1h 32 min. weitere 8,826 kg PO bei 1,36 bar zugeleitet. 22 Minuten nach Ende der PO-Dosierung wurde bei einem Restdruck von 0,674 bar Vakuum angelegt und vollständig entgast. Der Produkt wurde durch Zugabe von 5,27 g Irganox 1076 stabilisiert und als farblose, viskose Flüssigkeit erhalten (OH-Zahl 24,8 mg KOH/g, Viskosität bei 25°C: 1659 mPas).

Herstellung von Polyol 6:

In einen mit Rührwerk ausgestatteten 20 1 - Reaktionskessel wurden 3,621 kg eines difunktionellen Polytetrahydrofuranpolyetherpolyols (Equivalentgewicht 500 g/Mol OH) eingewogen und 525 mg DMC-Katalysator zugegeben. Dann wurde unter Rühren bei ca. 70 U/min. auf 105 °C erhitzt. Durch dreimaliges Anlegen von Vakuum und Entspannen mit Stickstoff wurde Luft gegen Stickstoff ausgetauscht. Nach Erhöhung der Rührerdrehzahl auf 300 U/min. wurde für 54 Minuten bei laufender Vakuumpumpe und einem Druck von etwa 0,1 bar von unten Stickstoff durch die Mischung geleitet. Danach wurden mittels Stickstoff ein Druck von 0,2 bar eingestellt und 363 g Propylenoxid (PO) zum Start der Polymerisation eingeleitet. Hierbei stieg der Druck auf 2,42 bar. Nach 7 Minuten war der Druck wieder auf 0,34 bar abgefallen und es wurden über einen Zeitraum von 2h 29 min. weitere 11,379 kg PO bei 2,9 bar eindosiert. 47 Minuten nach Ende der PO-Dosierung wurde bei einem Restdruck von 1,9 bar Vakuum angelegt und vollständig entgast. Der Produkt wurde durch Zugabe von 7,5 g Irganox 1076 stabilisiert und als farblose, viskose Flüssigkeit erhalten (OH-Zahl: 27,6 mg KOH/g, Viskosität bei 25°C: 1498 mPas).

Herstellung von Polyol 7:

In einen 11 - Edelstahlreaktor wurden 250 g eines difunktionellen Polytetrahydrofuranpolyetherpolyols (Equivalentgewicht 325 g/Mol OH) eingewogen und 22,1 mg DMC-Katalysator zugegeben. Durch fünfmaliges Anlegen von Vakuum und Entspannen mit Stickstoff wurde Luft gegen Stickstoff ausgetauscht, und dann unter Rühren bei ca. 800 U/min auf 125°C aufgeheizt. Anschließend wurde für 30 Minuten bei laufender Vakuumpumpe und einem Druck von etwa 0,1 bar von unten Stickstoff durch die Mischung geleitet. Bei 125°C wurde dann unter Rühren (800 U/min) während 90 Minuten eine Mischung aus 296 g PO und 197 g EO in den Reaktor dosiert. Nach vollständiger Epoxid-Dosierung wurde 45 Minuten bei 125°C unter Rühren nachreagiert und anschließend leicht flüchtige Anteile 30 Minuten bei 90°C im Hochvakuum abdestilliert. Nach Abkühlen auf Raumtemperatur wurde das Produkt aus dem Reaktor abgelassen und durch Zugabe von 500 ppm Irganox 1076 stabilisiert. Das Produkt wird als klare Flüssigkeit erhalten (OH-Zahl: 58,2 mg KOH/g, Viskosität bei 25°C: 471 mPas).

Herstellung von Polyol 8:

In einen 1 1 - Edelstahlreaktor wurden 350 g eines difunktionellen Polytetrahydrofuranpolyetherpolyols (Equivalentgewicht 500 g/Mol OH) eingewogen und 21,4 mg DMC-Katalysator zugegeben. Durch fünfmaliges Anlegen von Vakuum und Entspannen mit Stickstoff wurde Luft gegen Stickstoff ausgetauscht, und dann unter Rühren bei ca. 800 U/min auf 125°C aufgeheizt. Anschließend wurde für 30 Minuten bei laufender Vakuumpumpe und einem Druck von etwa 0,1 bar von unten Stickstoff durch die Mischung geleitet. Bei 125°C wurde dann unter Rühren (800 U/min) während 70 Minuten eine Mischung aus 218 g PO und 145 g EO in den Reaktor dosiert. Nach vollständiger Epoxid-Dosierung wurde 45 Minuten bei 125°C unter Rühren nachreagiert und anschließend leicht flüchtige Anteile 30 Minuten bei 90°C im Hochvakuum abdestilliert. Nach Abkühlen auf Raumtemperatur wurde das Produkt aus dem Reaktor abgelassen und durch Zugabe von 500 ppm Irganox 1076 stabilisiert. Das Produkt wird als bei Raumtemperatur farbloses Wachs erhalten (OH-Zahl: 59,2 mg KOH/g, Viskosität bei 25°C: 682 mPas).

Herstellung von Polyol 9:

In einen 11 - Edelstahlreaktor wurden 250 g eines difunktionellen Polytetrahydrofuranpolyetherpolyols (Equivalentgewicht 325 g/Mol OH) eingewogen und 22,1 mg DMC-Katalysator zugegeben. Durch fünfmaliges Anlegen von Vakuum und Entspannen mit Stickstoff wurde Luft gegen Stickstoff ausgetauscht, und dann unter Rühren bei ca. 800 U/min auf 125°C aufgeheizt. Anschließend wurde für 30 Minuten bei laufender Vakuumpumpe und einem Druck von etwa 0,1 bar von unten Stickstoff durch die Mischung geleitet. Bei 125°C wurden dann unter Rühren (800 U/min) während 60 Minuten 486 g PO in den Reaktor dosiert. Nach vollständiger Epoxid-Dosierung wurde 45 Minuten bei 125°C unter Rühren nachreagiert und anschließend leicht flüchtige Anteile 30 Minuten bei 90°C im Hochvakuum abdestilliert. Nach Abkühlen auf Raumtemperatur wurde das Produkt aus dem Reaktor abgelassen und durch Zugabe von 500 ppm Irganox 1076 stabilisiert. Das Produkt wird als klare Flüssigkeit erhalten (OH-Zahl: 55,1 mg KOH/g, Viskosität bei 25°C: 536 mPas).

Herstellung des Acrylates 3 (Phosphorthioyltris(oxy-4,1-phenyleniminocarbonyloxyethan-2,1-diyl)-triacrylat):

In einem 500 mL Rundkolben wurden 0.1 g 2,6-Di-tert.-butyl-4-methylphenol, 0.05 g Dibutylzinndilaurat (Desinorapid® Z, Bayer MaterialScience AG, Leverkusen, Deutschland) sowie und 213.07 g einer 27 %-igen Lösung von Tris(p-isocyanatophenyl)thiophosphat in Ethylacetat (Desmodur® RFE, Produkt der Bayer MaterialScience AG, Leverkusen, Deutschland) vorgelegt und auf 60 °C erwärmt. Anschließend wurden 42.37 g 2-Hydroxyethylacrylat zugetropft und die Mischung weiter auf 60 °C gehalten, bis der Isocyanatgehalt unter 0.1 % gesunken war. Danach wurde abgekühlt und im Vakuum das Ethylacetat vollständig entfernt. Das Produkt wurde als teilkristalliner Feststoff erhalten. $n_D^{20}$: 1,610.

Herstellung des Acrylates 4 2-({[3-(Methylsulfanyl)phenyl]carbamoyl}oxy)ethylprop-2-enoat):

In einem 100 mL Rundkolben wurden 0.02 g 2,6-Di-tert.-butyl-4-methylphenol, 0.01 g Desmorapid® Z, 11.7 g 3-(Methylthio)phenylisocyanat vorgelegt und vorgelegt und auf 60 °C erwärmt. Anschließend wurden 8.2 g 2-Hydroxyethylacrylat zugetropft und die Mischung weiter auf 60 °C gehalten, bis der Isocyanatgehalt unter 0.1 % gesunken war. Danach wurde abgekühlt. Das Produkt wurde als hellgelbe Flüssigkeit erhalten. $n_D^{20}$: 1,626.

Herstellung des Acrylates 5 (Mischung aus (4-Methylbenzol-1,3-diyl)bis[carbamoyloxy-3-(biphenyl-2-yloxy)propan-2,1-diyl]bisacrylat und (4-Methylbenzol-1,3-diyl)bis[carbamoyloxy-3-(biphenyl-2-yloxy)propan-1,2-diyl]bisacrylat und analoger Isomere):

430,2g Denacol EX 142 (Nagase-Chemtex, Japan), 129,7g Acrylsäure, 1,18g Triphenylphosphin und 0,0056g 2,6-Di-t.-butyl-4-methylphenol wurden in einem Dreihalskolben mit Rückflusskühler und Rührwerk vorgelegt. Zudem wurde Luft langsam durchgeleitet und auf 60 °C temperiert. Anschließend wird für 24 Stunden bei 90 °C gerührt. Man erhielt eine klare Flüssigkeit mit OHZ=157,8 mg KOH/g. 21,3g dieses Zwischenprodukts und 5,2g eines Gemischs aus 2,4 und 2,6-Toluidendiisocyanat (Desmodur T80, Bayer MaterialScience AG, Leverkusen, Germany) wurden in einem Dreihalskolben mit Rückflusskühler und Rührwerk vorgelegt. Zudem wurde Luft langsam durchgeleitet und auf 60 °C temperiert. Nach anfänglicher Exothermie das Produkt für 24 Stunden bei 60 °C gerührt. Es wurde ein klares, farbloses, gläsernes Produkt mit NCO = 0% erhalten. $n_D^{20}$: 1,643.

Herstellung des Acrylates 6 (Mischung von (4-Methylbenzol-1,3-diyl)bis(carbamoyloxy-3-phenoxypropan-2,1-diyl)bisacrylat and (4-Methylbenzol-1,3-diyl)bis(carbamoyloxy-3-phenoxypropan-1,2-diyl)bisacrylat und analoger Isomere):

112,7g Phenylglycidether, 54g Acrylsäure, 0,492g Triphenylphosphin und 0,0017g 2,6-Di-t.-butyl-4-methylphenol werden in einem Dreihalskolben mit Rückflusskühler und Rührwerk vorgelegt. Zudem wird Luft langsam durchgeleitet und dann auf 90 °C temperiert. Man rührt für 54 Stunden und erhält ein klares, flüssiges, hochviskoses Produkt. 22,4g dieses Produktes werden in einem Dreihalskolben mit Rückflusskühler und Rührwerk vorgelegt. Zudem wird Luft langsam durchgeleitet und auf 60 °C temperiert. Nun tropft man 8,7g 2,4-Toluidendiisocyanat (Desmodur T100, Bayer MaterialScience AG, Leverkusen, Germany) innerhalb von 30 Minuten unter Exothermiebildung zu. Man rührt für 20 Stunden und gibt dann 0.005g Dibutylzinndilaurat hinzu. Man erhält ein klares, hochviskoses Produkt mit NCO = 0%. $n_D^{20}$: 1,612.

Herstellung des Acrylates 7 ({[4-({[(1,1,1,3,3,3-Hexafluorpropan-2-yl)oxy]carbonyl}amino) phenoxy]phosphorothioyl}bis (oxybenzol-4,1-diylcarbamoyloxyethan-2,1-diyl)bisacrylat):

In einem 2 L Rundkolben wurden 0.5 g 2,6-Di-tert.-butyl-4-methylphenol, 0.25 g Dibutylzinndilaurat (Desmorapid Z, Bayer MaterialScience AG, Leverkusen, Deutschland) sowie und 1.00 kg einer 27 %-igen Lösung von Tris(p-isocyanatophenyl)thiophosphat in Ethylacetat (Desmodur® RFE, Produkt der Bayer MaterialScience AG, Leverkusen, Deutschland) vorgelegt und auf 60 °C erwärmt. Anschließend wurden 95.3 g Hexafluoroisopropanol zugetropft und die Temperatur für 8 h gehalten. Anschließend wurden 133.5 g 2-Hydroxyethylacrylat zugetropft und die Mischung weiter auf 60 °C gehalten, bis der Isocyanatgehalt unter 0.1 % gesunken war. Danach wurde abgekühlt und im Vakuum das Ethylacetat vollständig entfernt. Das Produkt wurde als farbloses Öl erhalten. $n_D^{20}$: 1,616.

Herstellung des Additives 1 (2.2,2-Tritluorethyl-butylcarbamat):

In einem 2000 mL Rundkolben wurden 0.50 g Desmorapid Z und 498 g n-Butylisocyanat vorgelegt und auf 60 °C erwärmt. Anschließend wurden 502 g Trifluorethanol zugetropft und die Mischung weiter auf 60 °C gehalten, bis der Isocyanatgehalt unter 0.1 % gesunken war. Danach wurde abgekühlt. Das Produkt wurde als farblose Flüssigkeit erhalten.

Die nachfolgend in Tabelle 1 beschriebenen Additive 2 bis 36 wurden auf analoge Art wie für Additiv 1 beschrieben in den angegebenen Zusammensetzungen hergestellt.

| Additiv | Name | Isocyanat und Menge | Alkohol und Menge | Katalysator und Menge | Temp [°C] | Beschreibung |
|---|---|---|---|---|---|---|
| **2** | 2,2,2-Trifluorethyl-hexylcarbamat | n-Hexylisocyanat 55.9 g | Trifluorethanol 44.0 g | Desmorapid Z 0,05 g | 60 °C | farblose Flüssigkeit |
| **3** | 1,1,1,3,3,3-Hexafluorpropan-2-yl-hexylcarbamat | n-Hexylisocyanat 10.8 g | Hexafluor-2-propanol 14.2 g | Desmorapid Z 0,01 g | 60 °C | farblose Flüssigkeit |
| **4** | 1,1,1,3,3,3-Hexafluorpropan-2-yl-butylcarbamat | n-Butylisocyanat 9.3 g | Hexafluor-2-propanol 15.7 g | Desmorapid Z 0,01 g | 60 °C | farbloser Feststoff |
| **5** | Bis(2,2,2-trifluorethyl)-(2,2,4-trimethylhexan-1,6-diyl) biscarbamat | 2,4,4-Trimethylhexane-1,6-diisocyanat (TMDI) 496 g | Trifluorethanol 463 g | Desmorapid Z 0,48 G | 60 °C | farblose Flüssigkeit |
| **6** | 2,2,3,3,4,4,4-Heptafluorbutyl-butylcarbamat | n-Butylisocyanat 24.8 g | 2,2,3,3,4,4,4-Heptafluorbutanol 50.1 g | Desmorapid Z 0,04 g | 60 °C | farbloser Feststoff |
| **7** | Bis(2,2,3,3,4,4,4-heptafluorbutyl)-[4-({[(2,2,3,3,4,4,4-heptafluorbutoxy) carbonyl]-amino}methyl)octan-1,8-diyl]biscarbamat | 1,8- Diisocyanato-4-(isocyanatomethyl)octan (TIN) 5.91 g | 2,2,3,3,4,4,4-Heptafluorbutanol 14.1 g | Desmorapid Z 0,01 g | 60 °C | farbloses Öl |
| **8** | 2,2,3,3,4,4,5,5,5-Nonafluorpentyl-butylcarbamat | n-Butylisocyanat 4,25 g | 2,2,3,3,4,4,5,5,5-Nonafluorpentan-1-ol 10,73 g | Desmorapid Z 0,02 g | 70 °C | farblose Flüssigkeit |
| **9** | 2,2,3,3,4,4,5,5,5-Nonafluorpentyl-hexylcarbamat | n-Hexylisocyanat 5,05 g | 2,2,3,3,4,4,5,5,5-Nonafluorpentan-1-ol 9,94 g | Desmorapid Z 0,02 g | 70 °C | farblose Flüssigkeit |
| **10** | 2,2,3,3,4,4,5,5,5-Nonafluorpentyl-cyclobexylcarbamat | Cyclohexylisocyanat 5,00 g | 2,2,3,3,4,4,5,5,5-Nonafluorpentan-1-ol 10,0 g | Desinorapid Z 0,02 g | 70 °C | farbloser Feststoff |
| **11** | Bis(2,2,3,3,4,4,5,5,6,6,7,7-dodecafluorheptyl)-(2,2,4-trimethylhexan-1,6-diyl) biscarbamat | 2,4,4-Triinethylhexane- 1 ,6-diisocyanat (TMDI) 3,60 g | 2,2,3,3,4,4,5,5,6,6,7,7-Dodecafluorheptan-1-ol 11,39 g | Desmorapid Z 0,02 g | 70 °C | farbloses Öl |

(fortgesetzt)

| Additiv | Name | Isocyanat und Menge | Alkohol und Menge | Katalysator und Menge | Temp [°C] | Beschreibung |
|---|---|---|---|---|---|---|
| **12** | 2,2,3,3,4,4,5,5,6,6,7,7-Dodecafluorheptyl-hexylcarbamat | n-Hexylisocyanat 4,15 g | 2,2,3,3,4,4,5,5,6,6,7,7-Dodecafluorheptan-1-ol 10,84 g | Desmorapid Z 0,02 g | 70 °C | farblose Flüssigkeit |
| **13** | 2,2,3,3,4,4,5,5,6,6,7,7-Dodecafluorheptyl-propan-2-ylcarbamat | i-Propylisocyanat 3,06 g | 2,2,3,3,4,4,5,5,6,6,7,7-Dodecafluorheptan-1-ol 11,93 g | Desmorapid Z 0,02 g | 70 °C | farblose Flüssigkeit |
| **14** | 2,2,3,3,4,4,5,5,6,6,7,7-Dodecafluorheptyl-cyclohexylcarbamat | Cyclohexylisocyanat 4,10 g | 2,2,3,3,4,4,5,5,6,6,7,7-Dodecafluorheptan-1-ol 10,88 g | Desmorapid Z 0,02 g | 70 °C | farblose Flüssigkeit |
| **15** | 2,2,3,4,4,4-Hexafluorbutyl-butylcarbamat | n-Butylisocyanat 5,28 g | 2,2,3,4,4,4-Hexafluorobutan-1-ol 9,71 g | Desmorapid Z 0,02 g | 70°C | farblose Flüssigkeit |
| **16** | Bis(2,2,3,4,4,4-hexafluorbutyl)-(2,2,4-trimethylhexan-1,6-diyl) biscarbamat | 2,4,4-Trimethylhexane-1,6-diisocyanat (TMDI) 5,48 g | 2,2,3,4,4,4-Hexafluorobutan-1-ol 9,50 g | Desmorapid Z 0,02 g | 70 °C | farbloses Öl |
| **17** | 2,2,3,4,4,4-Hexafluorbutyl-[3-({[(2,2,3,4,4,4-hexafluorbutoxy) carbonyl]amino}methyl)-3,5,5-trimethylcyclohexyl]carbamat | 1-Isocyanato-3,3,5-trimethyl-5-isocyanatomethylcyclohexan (IPDI) 5,67 g | 2,2,3,4,4,4-Hexafluorobutan-1-ol 9,31 g | Desmorapid Z 0,02 g | 70 °C | farbloses Öl |
| **18** | 2,2,3,4,4,4-Hexafluorbutyl-propan-2-ylcarbamat | i-Propylisocyanat 4,77 g | 2,2,3,4,4,4-Hexafluorobutau-1-ol 10,21 g | Desmorapid Z 0,02 g | 70 °C | farbloses Öl |
| **19** | 2,2,3,4,4,4-Hexafluorbutyl-cyclohexylcarbamat | Cyclohexylisocyanat 6,10 g | 2,2,3,4,4,4-Hexafluorobutan-1-ol 8,88 g | Desmorapid Z 0,02 g | 70 °C | farbloser Feststoff |
| **20** | 2,2,3,3,4,4,5,5-Octafluorpentyl-hexylcarbamat | n-Hexylisocyanat 5,30 g | 2,2,3,3,4,4,5,5-Octafluorpentan-1-ol 9,69 g | Desmorapid Z 0,02 g | 70 °C | farblose Flüssigkeit |

(fortgesetzt)

| Additiv | Name | Isocyanat und Menge | Alkohol und Menge | Katalysator und Menge | Temp [°C] | Beschreibung |
|---|---|---|---|---|---|---|
| **21** | 2,2,3,3,4,4,4-Heptafluorbutyl-hexylcarbamat | n-Hexylisocyanat 5,82 g | 2,2,3,3,4,4,4-Heptafluorbutan-1-ol 9,16 g | Desmorapid Z 0,02 g | 70 °C | farblose Flüssigkeit |
| **22** | 2,2,3,3,4,4.5,5,6,6,7,7,8,8,9,9-Hexadecafluomonyl-liexylcarbamat | n-Hexylisocyanat 3,40 g | 2,2,3,3,4,4,5,5,6,6,7,7, 8,8,9,9-Hexadecafluornouan-1-ol 11,6 g | Desmorapid Z 0,02 g | 70 °C | farbloser Feststoff |
| **23** | 1,1,1,3,3,3-Hexafluorpropan-2-yl-butylcarbamat | n-Butylisocyanat 6,96 g | 1,1,1-Tri fluorpropan-2-ol 8,02 g | Desmorapid Z 0,02 g | 70 °C | farblose Flüssigkeit |
| **24** | Bis(1,1,1,3,3,3-hexafluorpropan-2-yl)-{4-[({[(1,1,1,3,3,3-hexafluorpropan-2-yl)oxy]carbonyl} amino)methyl]octan-1,8-diyl} biscarbamat | 1,8-Diisocyanato-4-(isocyanatomethyl)octan (TIN) 6,36 g | 1,1,1 Trifluorpropan-2-ol 8,62 g | Desmorapid Z 0,02 g | 70 °C | farbloses Öl |
| **25** | 1,1,1,3,3,3-Hexafluorpropan-2-yl-hexylcarbamat | n-Hexylisocyanat 7,90 g | 1,1,1-Trifluorpropan-2-ol 7,08 g | Desmorapid Z 0,02 g | 70 °C | farblose Flüssigkeit |
| **26** | 1,1,1,3,3,3-Hexafluorpropan-2-yl-propan-2-ylcarbamat | i-Propylisocyanat 6,40 g | 1,1,1-Trifluorpropan-2-ol 8,58 g | Desmorapid Z 0,02 g | 70 °C | farbloser Feststoff |
| **27** | Bis(2,2,3,3-Tetratluoipropyl)-(cyclohexan-1,3-diyldimethandiyl)biscarbamat | 1,3-Bis-(isocyanatomethyl)-cyclohexan 6,35 g | Tetrafluor-1-propanol 8,63 g | Desmorapid Z 0,02 g | 70 °C | farbloser Feststoff |
| **28** | 2-Ethylhexyl-2,2,3,3,4,4,5,5,5-nonafluorpentyl-hexan-1,6-diylbiscarbamat | Desmodur LD 8,71 g | 2,2,3,3,4,4,5,5,5-Nonafluorpentan-1-ol 6,27 g | Desmorapid Z 0,02 g | 70 °C | farbloser Feststoff |
| **29** | 2,2,3,3,4,4,5,5,6,6,7,7-Dodecafluorheptyl-2-ethylhexyl-hexan-1,6-diylbiscarbamat | Desmodur LD 7,66 g | 2,2,3,3,4,4,5,5,6,6,7.7-Dodecafluorheptau-1-ol 7,32 g | Desmorapid Z 0,02 g | 70 °C | farbloser Feststoff |
| **30** | Bis(2,2,3,3,4,4,5,5,6,6,7,7-dodecafluorheptyl)-(cyclohexan-1,3-diyldimethandiyl)biscarbamat | 1,3-Bis-(isocyanatomethyl)-cyclohexan 3,39 g | 2,2,3,3,4,4,5,5,6,6,7,7-Dodecafluorheptan-1-ol 11,6 g | Desmorapid Z 0,02 g | 70 °C | farbloser Feststoff |

(fortgesetzt)

| Additiv | Name | Isocyanat und Menge | Alkohol und Menge | Katalysator und Menge | Temp [°C] | Beschreibung |
|---|---|---|---|---|---|---|
| **31** | Bis(1,1,1,3,3,3-hexafluorpropan-2-yl)-(2,2,4-trimethylhexan-1,6-diyl) biscarbamat | 2,4,4-Trimethylhexane-1,6-diisocyanat (TMDI) 50.0 g | Hexafluor-2-propanol 80.0 g | Desmorapid Z 0,07 g | 60 °C | farblose Flüssigkeit |
| **32** | 2,2,3,3,4,4,5,5,6,6,7,7,8,8,9,9-Hexadecafluornonyl-butylcarbamat | n-Butylisocyanat 186 g | 2,2,3,3,4,4,5,5,6,6,7,7,8,8,9,9-Hexadecafluomonanol 813 g | Desmorapid Z 0,50 g | 60 °C | farblose Flüssigkeit |
| **33** | Bis(2,2,3,3,4,4,4-heptafluorbutyl)-(2,2,4-trimethylhexan-1,6-diyl) bi$_s$carbamat | 2,4,4-Trimethylhexane-1,6-diisocyanat (TMDI) 6.88 g | 2,2,3,3,4,4,4-Heptafluorbutanol 13.1 g | Desmorapid Z 0,01 g | 60 °C | farblose Flüssigkeit |
| **34** | 2,2,3,3,4,4,5,5,6,6,7,7-Dodecafluorheptyl-butylcarbamat | n-Butylisocyanat 3,44 g | 2,2,3,3,4,4,5,5,6,6,7,7-Dodecafluorheptan-1-ol 11,54 g | Desmorapid Z 0,02 g | 70 °C | farblose Flüssigkeit |
| **35** | Bis(2,2,3,4,4,4-hexafluorbutyl)-[4-({[(2,2,3,4,4,4-hexafluorbutoxy) carbonyl]amino}methyl)octa n-1,8-diyl]biscarbamat | 1,8-Diisocyanato-4-(isocyanatomethyl)octan (TIN) 4,73 g | 2,2,3,4,4,4-Hexafluorobutan-1-ol 10,25 g | Desmorapid Z 0,02 g | 70 °C | farbloses Öl |
| **36** | 2,2,3,3,4,4,5,5,6,6,7,7,8,8,9,9-Hexadecafluornonyl-cyclohexylcarbamat | Cyclohexylisocyanat 3,37 g | 2,2,3,3,4,4,5,5,6,6,7,7,8,8,9,9-Hexadecafluornonan-1-ol 11,61 g | Desmorapid Z 0,02 g | 70 °C | farbloser Feststoff |

Herstellung von Additiv 37 (iso-Propyl-butylcarbamat):

In einem 250 mL Rundkolben wurden 0.02 g Desmorapid Z, 31.1 g n-Butylisocyanat vorgelegt und auf 60 °C erwärmt. Anschließend wurden 18.9 g iso-Propanol zugetropft und die Mischung weiter auf 60 °C gehalten, bis der Isocyanatgehalt unter 0.1 % gesunken war. Danach wurde abgekühlt und das Produkt wurde als klare Flüssigkeit erhalten.

Zur Herstellung der holografischen Medien werden die Schreibmonomere (Komponente c)), die Stabilisatoren (Komponente d)) (die bereits in der Komponente c) vorgelöst sein kann) sowie gegebenenfalls die Hilfs-und Zusatzstoffe (Komponente g)) in der isocyanat-reaktiven Komponente (Komponente b)) gegebenenfalls bei 60 °C gelöst, dann werden Glasperlen der Größe 10 oder 20 μm (z. B. der Fa. Whitehouse Scientific Ltd, Waverton, Chester, CH3 7PB, United Kingdom) zugegeben und gründlich gemischt. Danach wird im Dunklen oder unter geeigneter Beleuchtung der oder die Photoinitiatoren (zusammen Komponente e)) in reiner Form oder in verdünnter Lösung in N-Ethylpyrrolidon (Teil der Komponente g)) zugewogen und im erneut 1 Minute gemischt. Gegebenenfalls wird maximal 10 Minuten im Trockenschrank auf 60 °C erhitzt. Dann wird die Isocyanatkomponente (Komponente a)) zugegeben und wieder im 1 Minute gemischt. Im Folgenden wird eine Lösung des Katalysators (Komponente f)) zugegeben und im erneut 1 Minute gemischt. Die erhaltene Mischung wird unter Rühren bei < 1 mbar maximal 30 Sekunden entgast, dann wird sie auf Glasplatten von 50 x 75 mm verteilt und diese je mit einer weiteren Glasplatte abgedeckt. Die Härtung der PU-Formulierung erfolgt unter 15 kg Gewichten über mehrere Stunden (gewöhnlich über Nacht). Teilweise werden die Medien in lichtdichter Verpackung noch 2 Stunden bei 60 °C nachgehärtet. Die Dicke d der Photopolymerschicht ergibt sich aus dem Durchmesser der verwendeten Glaskugeln zu 20 μm. Da unterschiedliche Formulierungen mit unterschiedlicher Ausgangsviskosität und unterschiedlicher Härtungsgeschwindigkeit der Matrix zu nicht immer gleichen Schichtdicken d der Photopolymerschicht führen, wird d anhand der Charakteristika der geschriebenen Hologramme für jede Probe separat ermittelt. Analog zu dieser Vorschrift wurden die Medien der Vergleichsbeispiele 1 bis 27 und der Beispiele 1 bis 118 hergestellt.

Bei den folgenden Medien wurden als Matrixbausteine stets Polyol 2 (als Komponente b)) und Isocyanatkomponente 2 (als Komponente a)) eingesetzt und zwar so, dass das Verhältnis NCO : OH = 1,02 : 1 war und die Gesamtgewichtsprozent sich zu 100 % addieren. Alle Versuche wurden mit 0,1% Farbstoffen und 1,0% Coinitiator (zusammen Komponente e)), gelöst in 3,5% N-Ethylpyrrolidon (Komponente g)) sowie die angegebene Menge einer 10%-igen Lösung von Katalysator 1 in N-Ethylpyrrolidon (Komponente f)) durchgeführt.

| | Monomer 1 | Monomer 2 | Coinitiator | Farbstoff | Katalysator 1 | $\Delta n_{max.}$ |
|---|---|---|---|---|---|---|
| Vergleichs-bsp. 1 | Acrylat 4, 30% | - | 1 | Farbstoff 1, 0,05% und Farbstoff 2, 0,05% | 0,21% | 0,0172 |
| Vergleichsbsp. 2 | Acrylat 3, 30% | - | 1 | Farbstoff 1, 0,05% und Farbstoff 2, 0,05% | 0,20% | 0,0144 |
| Beispiel 1 | Acrylat 4, 15% | Acrylat 3, 15% | 1 | Farbstoff 1, 0,05% und Farbstoff 2, 0,05% | 0,24% | 0,0175 |
| Beispiel 2 | Acrylat 4, 20% | Acrylat 3, 10% | 1 | Farbstoff 1, 0,05% und Farbstoff 2, 0,05% | 0,20% | 0,0182 |
| Beispiel 3 | Acrylat 4, 22,5% | Acrylat 3, 7,5% | 1 | Farbstoff 1, 0,05% und Farbstoff 2, 0,05% | 0,20% | 0,0203 |
| Vergleichsbsp. 3 | Acrylat 1, 40% | - | 1 | Farbstoff 1, 0,10% | 0,20% | 0 |
| Vergleichsbsp. 4 | Acrylat 3, 40% | - | 1 | Farbstoff 1, 0,10% | 0,20% | 0,0172 |

(fortgesetzt)

| | Monomer 1 | Monomer 2 | Coinitiator | Farbstoff | Katalysator 1 | $\Delta n_{max.}$ |
|---|---|---|---|---|---|---|
| Vergleichsbsp. 5 | Acrylat 4, 40% | - | 1 | Farbstoff 1, 0,10% | 0,20% | 0,0140 |
| Beispiel 4 | Acrylat 1, 20% | Acrylat 3, 20% | 1 | Farbstoff 1, 0,10% | 0,21% | 0,0197 |
| Beispiel 5 | Acrylat 1, 20% | Acrylat 4, 20% | 1 | Farbstoff 2, 0,10% | 0,18% | 0,0211 |
| Beispiel 6 | Acrylat 3, 20% | Acrylat 4, 20% | 1 | Farbstoff 2, 0,10% | 0,17% | 0,0206 |

Bei den folgenden Medien wurden als Matrixbausteine stets Polyol 1 (als Komponente b)) und Isocyanatkomponente 1 (als Komponente a)) eingesetzt und zwar so, dass das Verhältnis NCO : OH = 1,02 : 1 war und die Gesamtgewichtsprozent sich zu 100 % addieren:

| | Monomer 1 | Monomer 2 | Coinitiator | Farbstoff | Katalysator 1 | $\Delta n_{max.}$ |
|---|---|---|---|---|---|---|
| Vergleichs-bsp. 6 | Acrylat 3, 30% | - | 1 | Farbstoff 1, 0,10% | 0,02%* | 0,0091 |
| Vergleichs-bsp. 7 | Acrylat 3, 40% | - | 1 | Farbstoff 1, 0,10% | 0,06% | 0,0079 |
| Vergleichs-bsp. 8 | Acrylat 3, 50% | - | 1 | Farbstoff 1, 0,10% | 0,10% | 0,0045 |
| Vergleichsbsp. 9 | Acrylat 2, 30% | - | 1 | Farbstoff 1, 0,10% | 0,20% | 0,0002 |
| Vergleichs-bsp. 10 | Acrylat 2, 40% | - | 1 | Farbstoff 1, 0,10% | 0,20% | 0,0002 |
| Beispiel 7 | Acrylat 3, 20% | Acrylat 2, 20% | 1 | Farbstoff 1, 0,10% | 0,20% | 0,0094 |
| Vergleichs-bsp. 11 | Acrylat 4, 30% | - | 1 | Farbstoff 1, 0,10% | 0,10% | 0,0056 |
| Vergleichsbsp. 12 | Acrylat 4, 40% | - | 1 | Farbstoff 1, 0,10% | 0,10% | 0,0096 |
| Vergleichsbsp. 13 | Acrylat 4, 50% | - | 1 | Farbstoff 1, 0,10% | 0,10% | 0,0112 |
| Beispiel 8 | Acrylat 3, 15% | Acrylat 4, 15% | 1 | Farbstoff 1, 0,10% | 0,10% | 0,0127 |
| Beispiel 9 | Acrylat 3, 20% | Acrylat 4, 20% | 1 | Farbstoff 1, 0,10% | 0,06% | 0,0140 |
| Beispiel 10 | Acrylat 3, 25% | Acrylat 4, 25% | 1 | Farbstoff 1, 0,10% | 0,10% | 0,0149 |
| Vergleichsbsp. 14 | Acrylat 5, 40% | - | 1 | Farbstoff 1, 0,10% | 0,20% | 0,0088 |
| Beispiel 11 | Acrylat 5, 30% | Acrylat 4, 10% | 1 | Farbstoff 1, 0,10% | 0,20% | 0,0139 |
| Beispiel 12 | Acrylat 5, 20% | Acrylat 4, 20% | 1 | Farbstoff 1, 0,10% | 0,20% | 0,0140 |

(fortgesetzt)

| | Monomer 1 | Monomer 2 | Coinitiator | Farbstoff | Katalysator 1 | $\Delta n_{max.}$ |
|---|---|---|---|---|---|---|
| Beispiel 13 | Acrylat 5, 10% | Acrylat 4, 30% | 1 | Farbstoff 1, 0,10% | 0,20% | 0,0147 |
| * als 10%-ige Lösung in Butylacetat eingesetzt. | | | | | | |

Bei den folgenden Medien wurden als Matrixbausteine stets Polyol 3 (als Komponente b)) und Isocyanatkomponente 3 (als Komponente a)) eingesetzt und zwar so, dass das Verhältnis NCO : OH = 1,02 : 1 war und die Gesamtgewichtsprozent sich zu 100 % addieren:

| | Monomer 1 | Monomer 2 | Coinitiator | Farbstoff | Katalysator | $\Delta n_{max.}$ |
|---|---|---|---|---|---|---|
| Vergleichs-bsp. 15 | Acrylat 1, 40% | - | 1 | Farbstoff 3, 0,10% | 0,20% | 0,0094 |
| Vergleichs-bsp. 16 | Acrylat 3, 40% | - | 1 | Farbstoff 3, 0,10% | 0,20% | 0,0152 |
| Vergleichsbsp. 17 | Acrylat 3, 50% | - | 1 | Farbstoff 3, 0,10% | 0,20% | 0,0116 |
| Vergleichs-bsp. 18 | Acrylat 4, 40% | - | 1 | Farbstoff 3, 0,10% | 0,20% | 0,0148 |
| Vergleichs-bsp. 19 | Acrylat 4, 50% | - | 1 | Farbstoff 3, 0,10% | 0,20% | 0,0134 |
| Beispiel 14 | Acrylat 1, 20% | Acrylat 3, 20% | 1 | Farbstoff 3, 0,10% | 0,20% | 0,0114 |
| Beispiel 15 | Acrylat 1, 20% | Acrylat 3, 20% | 1 | Farbstoff 1, 0,10% | 0,20% | 0,0206 |
| Beispiel 16 | Acrylat 3, 20% | Acrylat 4, 20% | 1 | Farbstoff 3, 0,10% | 0,20% | 0,0225 |
| Beispiel 17 | Acrylat 3, 25% | Acrylat 4, 25% | 1 | Farbstoff 3, 0,10% | 0,17% | 0,0260 |
| Beispiel 18 | Acrylat 3, 15% | Acrylat 4, 35% | 1 | Farbstoff 3, 0,10% | 0,18% | 0,0264 |

Bei den folgenden Medien wurden als Matrixbausteine stets Polyol 3 (als Komponente b)) und Isocyanatkomponente 4 (als Komponente a)) eingesetzt und zwar so, dass das Verhältnis NCO : OH = 1,02 : 1 war und die Gesamtgewichtsprozent sich zu 100 % addieren:

| | Monomer 1 | Monomer 2 | Coinitiator | Farbstoff | Katalysator | $\Delta n_{max.}$ |
|---|---|---|---|---|---|---|
| Vergleichs-bsp. 20 | Acrylat 3, 40% | - | 1 | Farbstoff 3, 0,10% | 0,20% | 0,0105 |
| Vergleichs-bsp. 21 | Acrylat 3, 50% | - | 1 | Farbstoff 3, 0,10% | 0,20% | 0,0078 |
| Vergleichs-bsp. 22 | Acrylat 4, 40% | - | 1 | Farbstoff 3, 0,10% | 0,20% | 0,0127 |
| Vergleichs-bsp. 23 | Acrylat 4, 50% | - | 1 | Farbstoff 3, 0,10% | 0,20% | 0,0130 |
| Beispiel 19 | Acrylat 3, 20% | Acrylat 4, 20% | 1 | Farbstoff 3, 0,10% | 0,21% | 0,0197 |
| Beispiel 20 | Acrylat 3, 25% | Acrylat 4, 25% | 1 | Farbstoff 3, 0,10% | 0,19% | 0,0330 |

(fortgesetzt)

| | Monomer 1 | Monomer 2 | Coinitiator | Farbstoff | Katalysator | $\Delta n_{max.}$ |
|---|---|---|---|---|---|---|
| Beispiel 21 | Acrylat 3, 15% | Acrylat 4, 35% | 1 | Farbstoff 3, 0,10% | 0,20% | 0,0297 |

Bei den folgenden Medien wurden als Matrixbausteine stets Polyol 4 (als Komponente b)) und Isocyanatkomponente 4 (als Komponente a)) eingesetzt und zwar so, dass das Verhältnis NCO : OH = 1,02 : 1 war und die Gesamtgewichtsprozent sich zu 100 % addieren:

| | Monomer 1 | Monomer 2 | Coinitiator | Farbstoff | Katalysator | $\Delta n_{max.}$ |
|---|---|---|---|---|---|---|
| Vergleichsbsp. 24 | Acrylat 3, 40% | - | Coinitiator 1, 1,0% | Farbstoff 1, 0,10% | 0,20% | 0,0171 |
| Vergleichsbsp. 25 | Acrylat 3, 50% | - | Coinitiator 1, 1,0% | Farbstoff 1, 0,10% | 0,20% | 0,0159 |
| Vergleichsbsp. 26 | Acrylat 4, 40% | - | Coinitiator 1, 1,0% | Farbstoff 1, 0,10% | 0,20% | 0,0068 |
| Vergleichs-bsp. 27 | Acrylat 4, 50% | - | Coinitiator 1, 1,0% | Farbstoff 1, 0,10% | 0,20% | 0,0055 |
| Beispiel 22 | Acrylat 3, 30% | Acrylat 4, 10% | Coinitiator 1, 1,0% | Farbstoff 1, 0,10% | 0,20% | 0,0178 |
| Beispiel 23 | Acrylat 3, 20% | Acrylat 4, 20% | Coinitiator 1, 1,0% | Farbstoff 1, 0,10% | 0,20% | 0,0189 |
| Beispiel 24 | Acrylat 3, 10% | Acrylat 4, 30% | Coinitiator 1, 1,0% | Farbstoff 1, 0,10% | 0,20% | 0,0177 |
| Beispiel 25 | Acrylat 3, 20% | Acrylat 4, 20% | Coinitiator 2, 3,0% | Farbstoff 1, 0,10% | 0,20% | 0,021 |
| Beispiel 26 | Acrylat 3, 25% | Acrylat 4, 25% | Coinitiator 1, 1,0% | Farbstoff 1, 0,10% | 0,20% | 0,0185 |

Als Beispiele für die als bevorzugt genannte Formulierung (mit (Fluor-)Urethanen als Additiv) werden gezeigt:

Bei den folgenden Medien wurden als Matrixbausteine stets Polyol 1 (als Komponente b)) und Isocyanatkomponente 1 (als Komponente a)) eingesetzt und zwar so, dass das Verhältnis NCO : OH = 1,02 : 1 war und die Gesamtgewichtsprozent sich zu 100 % addieren. Dabei wurden stets 20 Gewichts-% von Acrylat 3, 20 Gewichts-% von Acrylat 4 (zusammen Komponente c.)), 0,060 Gewichts-% der 10%-igen Lösung von Katalysator 1 in N-Ethylpyrrolidon (Komponente f)), 1,0 Gewichts-% des Coinitiators 1 und 0,10 Gewichts-% des Farbstoffes 1 (zusammen Komponente e)) sowie 15% des entsprechenden Additives (Komponente g)) eingesetzt:

| | Additiv | $\Delta n_{max.}$ |
|---|---|---|
| Beispiel 27 | 1 | 0,0253 |
| Beispiel 28 | 2 | 0,0238 |
| Beispiel 29 | 3 | 0,0302 |
| Beispiel 30 | 4 | 0,0305 |
| Beispiel 31 | 5 | 0,0205 |
| Beispiel 32 | 6 | 0,0310 |
| Beispiel 33 | 7 | 0,0175 |
| Beispiel 34 | 8 | 0,0365 |
| Beispiel 35 | 9 | 0,0348 |

(fortgesetzt)

| | **Additiv** | $\Delta n_{max.}$ |
|---|---|---|
| Beispiel 36 | 10 | 0,0295 |
| Beispiel 37 | 11 | 0,0320 |
| Beispiel 38 | 12 | 0,0310 |
| Beispiel 39 | 13 | 0,0310 |
| Beispiel 40 | 14 | 0,0245 |
| Beispiel 41 | 15 | 0,0250 |
| Beispiel 42 | 16 | 0,0250 |
| Beispiel 43 | 17 | 0,0230 |
| Beispiel 44 | 18 | 0,0260 |
| Beispiel 45 | 19 | 0,0225 |
| Beispiel 46 | 20 | 0,0239 |
| Beispiel 47 | 21 | 0,0286 |
| Beispiel 48 | 22 | 0,0283 |
| Beispiel 49 | 23 | 0,0220 |
| Beispiel 50 | 24 | 0,0229 |
| Beispiel 51 | 25 | 0,0235 |
| Beispiel 52 | 26 | 0,0245 |
| Beispiel 53 | 27 | 0,0184 |
| Beispiel 54 | 28 | 0,0260 |
| Beispiel 55 | 29 | 0,0269 |
| Beispiel 56 | 30 | 0,0305 |

Bei den folgenden Medien wurden folgende Komponenten verwendet. Die Differenz der Summe der Gesamtgewichtsprozent zu 100 % entspricht jeweils der Menge N-Ethylpyrrolidon, die für das Lösen von Farbstoff und Coinitiator verwendet wurde:

| Beispiel-Nr. | Polyol-Nr. (als Komponente b)) | Anteil (Gew.-%) | Isocyanat Komponente (als Komponente a)) | Anteil (Gew.-%) | Acrylat-Nr. (1. Monomer) (Komponente c)) | Anteil (Gew.-%) | Acrylat-Nr. (2. Monomer) (Komponente c)) | Anteil (Gew.-%) | Additiv-Nr. (Komponente g)) | Anteil (Gew.-%) | Coinitiator (Komponente e)) | Anteil (Gew.-%) | Farbstoff (Komponente e)) | Anteil (Gew.-%) | Katalysator 1 (Gew.-%) (Komponente f)) | Δn(max.) |
|---|---|---|---|---|---|---|---|---|---|---|---|---|---|---|---|---|
| 57 | 1 | 34,1 | 1 | 6,3 | 5 | 20 | 4 | 20 | 11 | 15 | 1 | 1,0 | 1 | 0,1 | 0,06 | 0,0355 |
| 58 | 1 | 34,0 | 1 | 6,2 | 3 | 20 | 7 | 20 | 11 | 15 | 1 | 1,0 | 1 | 0,1 | 0,20 | 0,0261 |
| 59 | 1 | 38,3 | 1 | 7,0 | 3 | 15 | 4 | 15 | 37 | 20 | 1 | 1,0 | 1 | 0,1 | 0,20 | 0,0157 |
| 60 | 2 | 29,5 | 2 | 10,8 | 3 | 15 | 4 | 15 | 11 | 25 | 1 | 1,0 | 1 | 0,1 | 0,20 | 0,0330 |
| 61 | 10 | 23,8 | 2 | 16,4 | 3 | 25 | 4 | 15 | 32 | 15 | 1 | 1,0 | 1 | 0,1 | 0,21 | 0,0265 |
| 62 | 4 | 36,4 | 3 | 3,8 | 3 | 15 | 4 | 15 | 32 | 25 | 1 | 1,0 | 1 | 0,1 | 0,20 | 0,0370 |
| 63 | 4 | 36,4 | 3 | 3,8 | 3 | 15 | 4 | 15 | 6 | 25 | 1 | 1,0 | 1 | 0,1 | 0,20 | 0,0376 |
| 64 | 4 | 36,4 | 3 | 3,8 | 3 | 25 | 4 | 15 | 32 | 15 | 1 | 1,0 | 1 | 0,1 | 0,20 | 0,0375 |
| 65 | 4 | 36,4 | 3 | 3,8 | 3 | 25 | 4 | 15 | 6 | 15 | 1 | 1,0 | 1 | 0,1 | 0,20 | 0,0385 |
| 66 | 4 | 36,4 | 3 | 3,8 | 3 | 25 | 4 | 15 | 31 | 15 | 1 | 1,0 | 1 | 0,1 | 0,21 | 0,0400 |
| 67 | 4 | 36,4 | 3 | 3,8 | 3 | 25 | 4 | 15 | 6 | 15 | 1 | 1,0 | 3 | 0,1 | 0,22 | 0,0410 |
| 68 | 4 | 36,4 | 3 | 3,8 | 3 | 25 | 4 | 15 | 31 | 15 | 1 | 1,0 | 3 | 0,1 | 0,20 | 0,0390 |
| 69 | 5 | 36,7 | 3 | 3,5 | 3 | 25 | 4 | 15 | 32 | 15 | 1 | 1,0 | 1 | 0,1 | 0,21 | 0,0480 |
| 70 | 5 | 36,7 | 3 | 3,5 | 3 | 25 | 4 | 15 | 33 | 15 | 1 | 1,0 | 1 | 0,1 | 0,20 | 0,0450 |
| 71 | 4 | 36,4 | 3 | 3,8 | 6 | 25 | 4 | 15 | 31 | 15 | 1 | 1,0 | 1 | 0,1 | 0,21 | 0,0284 |
| 72 | 4 | 35,4 | 4 | 4,8 | 3 | 25 | 4 | 15 | 32 | 15 | 1 | 1,0 | 1 | 0,1 | 0,21 | 0,0370 |
| 73 | 4 | 35,4 | 4 | 4,8 | 3 | 15 | 4 | 15 | 32 | 25 | 1 | 1,0 | 1 | 0,1 | 0,20 | 0,0365 |
| 74 | 4 | 35,9 | 4 | 4,3 | 3 | 25 | 4 | 15 | 32 | 15 | 1 | 1,0 | 3 | 0,1 | 0,20 | 0,0430 |
| 75 | 4 | 35,4 | 4 | 4,8 | 3 | 25 | 4 | 15 | 36 | 15 | 1 | 1,0 | 1 | 0,1 | 0,19 | 0,0330 |
| 76 | 4 | 35,4 | 4 | 4,8 | 3 | 25 | 4 | 15 | 21 | 15 | 1 | 1,0 | 1 | 0,1 | 0,20 | 0,0375 |
| 77 | 4 | 35,4 | 4 | 4,8 | 3 | 30 | 4 | 10 | 11 | 15 | 1 | 1,0 | 1 | 0,1 | 0,22 | 0,0373 |
| 78 | 4 | 35,4 | 4 | 4,8 | 3 | 20 | 4 | 20 | 11 | 15 | 1 | 1,0 | 1 | 0,1 | 0,18 | 0,0397 |
| 79 | 4 | 35,4 | 4 | 4,8 | 3 | 15 | 4 | 25 | 11 | 15 | 1 | 1,0 | 1 | 0,1 | 0,20 | 0,0414 |
| 80 | 4 | 35,4 | 4 | 4,8 | 3 | 10 | 4 | 30 | 11 | 15 | 1 | 1,0 | 1 | 0,1 | 0,18 | 0,0391 |
| 81 | 4 | 34,4 | 4 | 4,8 | 3 | 5 | 4 | 35 | 11 | 15 | 1 | 1,0 | 1 | 0,1 | 0,20 | 0,0376 |
| 82 | 4 | 35,4 | 4 | 4,8 | 3 | 15 | 4 | 15 | 11 | 25 | 1 | 1,0 | 1 | 0,1 | 0,20 | 0,0387 |
| 83 | 4 | 35,4 | 4 | 4,8 | 3 | 25 | 4 | 5 | 11 | 25 | 1 | 1,0 | 1 | 0,1 | 0,21 | 0,0382 |

| | | | | | | | | | | | | | | | | |
|---|---|---|---|---|---|---|---|---|---|---|---|---|---|---|---|---|
| 84 | 4 | 35,4 | 4 | 4,8 | 3 | 5 | 4 | 25 | 11 | 25 | 1 | 1,0 | 1 | 0,1 | 0,20 | 0,0331 |
| 85 | 4 | 35,4 | 4 | 4,8 | 5 | 20 | 4 | 20 | 11 | 15 | 1 | 1,0 | 1 | 0,1 | 0,20 | 0,0295 |
| 86 | 4 | 35,4 | 4 | 4,8 | 3 | 25 | 4 | 15 | 34 | 15 | 1 | 1,0 | 1 | 0,1 | 0,20 | 0,0365 |
| 87 | 4 | 35,4 | 4 | 4,8 | 3 | 25 | 4 | 15 | 35 | 15 | 1 | 1,0 | 1 | 0,1 | 0,20 | 0,0340 |
| 88 | 4 | 35,7 | 4 | 4,6 | 3 | 25 | 4 | 15 | 31 | 15 | 1 | 1,0 | 1 | 0,1 | 0,20 | 0,0375 |
| 89 | 4 | 35,4 | 4 | 4,8 | 3 | 20 | 4 | 20 | 8 | 15 | 1 | 1,0 | 1 | 0,1 | 0,21 | 0,0398 |
| 90 | 4 | 35,4 | 4 | 4,8 | 3 | 20 | 4 | 20 | 9 | 15 | 1 | 1,0 | 1 | 0,1 | 0,21 | 0,0365 |
| 91 | 4 | 35,4 | 4 | 4,8 | 3 | 20 | 4 | 20 | 10 | 15 | 1 | 1,0 | 1 | 0,1 | 0,20 | 0,0278 |
| 92 | 4 | 35,4 | 4 | 4,8 | 3 | 20 | 4 | 20 | 24 | 15 | 1 | 1,0 | 1 | 0,1 | 0,20 | 0,0245 |
| 93 | 4 | 33,7 | 4 | 4,6 | 3 | 20 | 4 | 20 | 11 | 15 | 2 | 3,0 | 1 | 0,1 | 0,20 | 0,0435 |
| 94 | 4 | 33,7 | 4 | 4,6 | 3 | 20 | 4 | 20 | 36 | 15 | 2 | 3,0 | 1 | 0,1 | 0,20 | 0,0379 |
| 95 | 4 | 31,4 | 4 | 3,8 | 3 | 20 | 4 | 20 | 31 | 20 | 1 | 1,0 | 2 | 0,1 | 0,20 | 0,0455 |
| 96 | 4 | 31,4 | 4 | 3,8 | 3 | 20 | 4 | 20 | 11 | 20 | 1 | 1,0 | 2 | 0,1 | 0,21 | 0,0450 |
| 97 | 4 | 35,4 | 4 | 4,8 | 3 | 15 | 7 | 15 | 11 | 25 | 1 | 1,0 | 1 | 0,1 | 0,20 | 0,0289 |
| 98 | 4 | 35,4 | 4 | 4,8 | 3 | 20 | 7 | 20 | 11 | 15 | 1 | 1,0 | 1 | 0,1 | 0,20 | 0,0280 |
| 99 | 4 | 35,4 | 4 | 4,8 | 3 | 20 | 5 | 20 | 11 | 15 | 1 | 1,0 | 1 | 0,1 | 0,20 | 0,0300 |
| 100 | 4 | 35,4 | 4 | 4,8 | 3 | 15 | 5 | 15 | 11 | 25 | 1 | 1,0 | 1 | 0,1 | 0,20 | 0,0280 |
| 101 | 5 | 35,7 | 4 | 4,5 | 3 | 20 | 4 | 20 | 33 | 15 | 1 | 1,0 | 1 | 0,1 | 0,20 | 0,0436 |
| 102 | 5 | 31,3 | 4 | 4,0 | 3 | 20 | 4 | 20 | 32 | 20 | 1 | 1,0 | 2 | 0,1 | 0,21 | 0,0470 |
| 103 | 5 | 35,7 | 4 | 4,5 | 3 | 25 | 4 | 15 | 21 | 15 | 1 | 1,0 | 2 | 0,1 | 0,20 | 0,0361 |
| 104 | 7 | 31,7 | 4 | 8,6 | 3 | 25 | 4 | 15 | 32 | 15 | 1 | 1,0 | 1 | 0,1 | 0,20 | 0,0379 |
| 105 | 8 | 31,6 | 4 | 8,6 | 3 | 25 | 4 | 15 | 32 | 15 | 1 | 1,0 | 1 | 0,1 | 0,20 | 0,0377 |
| 106 | 7 | 31,7 | 4 | 8,6 | 3 | 25 | 4 | 15 | 11 | 15 | 1 | 1,0 | 1 | 0,1 | 0,20 | 0,0324 |
| 107 | 8 | 31,6 | 4 | 8,6 | 3 | 25 | 4 | 15 | 11 | 15 | 1 | 1,0 | 1 | 0,1 | 0,20 | 0,0334 |
| 108 | 9 | 32,1 | 4 | 8,1 | 3 | 25 | 4 | 15 | 11 | 15 | 1 | 1,0 | 1 | 0,1 | 0,20 | 0,0337 |
| 109 | 3 | 32,3 | 1 | 2,9 | 3 | 20 | 4 | 20 | 32 | 20 | 1 | 1,0 | 2 | 0,1 | 0,21 | 0,0389 |
| 110 | 6 | 32,4 | 1 | 2,9 | 3 | 20 | 4 | 20 | 32 | 20 | 1 | 1,0 | 2 | 0,1 | 0,19 | 0,0400 |
| 111 | 6 | 32,4 | 1 | 2,9 | 3 | 20 | 4 | 20 | 21 | 20 | 1 | 1,0 | 2 | 0,1 | 0,20 | 0,0440 |
| 112 | 6 | 31,4 | 4 | 3,9 | 3 | 20 | 4 | 20 | 32 | 20 | 1 | 1,0 | 2 | 0,1 | 0,22 | 0,0415 |
| 113 | 6 | 31,4 | 4 | 3,9 | 3 | 20 | 4 | 20 | 21 | 20 | 1 | 1,0 | 2 | 0,1 | 0,20 | 0,0400 |
| 114 | 6 | 31,4 | 4 | 3,9 | 3 | 20 | 4 | 20 | 22 | 20 | 1 | 1,0 | 2 | 0,1 | 0,20 | 0,0470 |
| 115 | 4 | 33,4 | 5 | 6,8 | 3 | 25 | 4 | 15 | 32 | 15 | 1 | 1,0 | 1 | 0,1 | 0,20 | 0,0430 |
| 116 | 4 | 31,2 | 5 | 7,1 | 3 | 25 | 4 | 15 | 32 | 15 | 2 | 3,0 | 1 | 0,1 | 0,20 | 0,0483 |
| 117 | 4 | 36,9 | 6 | 3,3 | 3 | 25 | 4 | 15 | 32 | 15 | 1 | 1,0 | 1 | 0,1 | 0,20 | 0,0402 |
| 118 | 4 | 29,3 | 2 | 11,0 | 3 | 25 | 4 | 15 | 32 | 15 | 1 | 1,0 | 1 | 0,1 | 0,20 | 0,0360 |

## Patentansprüche

1. Photopolymer-Formulierung umfassend Matrixpolymere, eine Kombination von wenigstens zwei verschiedenen Schreibmonomeren und Photoinitiatoren, wobei die Matrixpolymere Polyurethane sind, **dadurch gekennzeichnet, dass** sich die Schreibmonomere in ihren jeweiligen bei einer Wellenlänge von 405 nm gemessenen Brechungsindizes $n_D^{20}$ um nicht mehr als 0,200 unterscheiden und jeweils einen bei einer Wellenlänge von 405 nm gemessenen Brechungsindex $n_D^{20}$ von ≥ 1,45 aufweisen.

2. Photopolymer-Formulierung nach Anspruch 1, **dadurch gekennzeichnet, dass** sich die Schreibmonomere in ihren jeweiligen bei einer Wellenlänge von 405 nm gemessenen Brechungsindizes $n_D^{20}$ um nicht mehr als 0,100 und insbesondere nicht mehr als 0,065 unterscheiden und jeweils einen bei einer Wellenlänge von 405 nm gemessenen Brechungsindex $n_D^{20}$, von ≥ 1,50 und besonders bevorzugt von ≥ 1,55 aufweisen.

**3.** Photopolymer-Formulierung nach einem der Ansprüche 1 oder 2, **dadurch gekennzeichnet, dass** die Schreibmonomere Acrylate und / oder Methacrylate, bevorzugt Urethanacrylate und / oder Urethanmethacrylate sind.

**4.** Photopolymer-Formulierung nach Anspruch 3, **dadurch gekennzeichnet, dass** die Schreibmonomere mono-, di-, tri-, und / oder multifunktional sind.

**5.** Photopolymer-Formulierung nach Anspruch 4, **dadurch gekennzeichnet, dass** sie eine Kombination eines monofunktionalen und eines multifunktionalen, insbesondere di- oder trifunktionalen Schreibmonomers oder die Kombination aus einem di- und einem trifunktionellen Schreibmonomer enthält.

**6.** Photopolymer-Formulierung nach einem der Ansprüche 1 bis 5, **dadurch gekennzeichnet, dass** die Matrixpolymere Polyurethane sind, die durch Umsetzung einer Isocyanatkomponente a) mit einer Isocyanat-reaktiven Komponente b) erhältlich sind.

**7.** Photopolymer-Formulierung nach einem der Ansprüche 1 bis 6, **dadurch gekennzeichnet, dass** die es sich bei den Photoinitiatoren um durch aktinische Strahlung aktivierbare Initiatoren handelt.

**8.** Photopolymer-Formulierung nach einem der Ansprüche 1 bis 7, **dadurch gekennzeichnet, dass** sie Weichmacher enthält.

**9.** Photopolymer-Formulierung nach Anspruch 8. **dadurch gekennzeichnet, dass** die Weichmacher Urethane und / oder fluorierte Urethane sind.

**10.** Photopolymer-Formulierung nach Anspruch 9, **dadurch gekennzeichnet, dass** die Urethane die allgemeine Formel IV

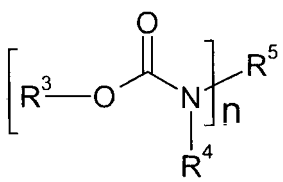

Formel IV

haben, in der $n \geq 1$ und $n \leq 8$ ist und $R^3$, $R^4$, $R^5$ Wasserstoff und / oder unabhängig voneinander lineare, verzweigte, cyclische oder heterocyclische unsubstituierte oder gegebenenfalls auch mit Heteroatomen substituierte organische Reste sind, wobei bevorzugt mindestens einer der Reste $R^3$, $R^4$, $R^5$ mit wenigstens einem Fluoratom substituiert ist und besonders bevorzugt $R^3$ ein organischer Rest mit mindestens einem Fluoratom ist.

**11.** Photopolymer-Formulierung nach einem der Ansprüche 1 bis 10, **dadurch gekennzeichnet, dass** sie 10 bis 89,999 Gew.-%, bevorzugt 25 bis 70 Gew.-% Matrixpolymere, 10 bis 60 Gew.-%, bevorzugt 25 bis 50 Gew.-% Schreibmonomere, 0,001 bis 5 Gew.-% Photoinitiatoren und gegebenenfalls 0 bis 4 Gew.-%, bevorzugt 0 bis 2 Gew.-% Katalysatoren, 0 bis 5 Gew.-%, bevorzugt 0,001 bis 1 Gew.-% Radikalstabilisatoren 0 bis 30 Gew.-%, bevorzugt 0 bis 25 Gew.-% Weichmacher und 0 bis 5 Gew.-%, bevorzugt 0,1 bis 5 Gew.-% weitere Additive enthält, wobei die Summe aller Bestandteile 100 Gew.-% beträgt.

**12.** Verwendung einer Photopolymer-Formulierung nach einem der Ansprüche 1 bis 11 zur Herstellung von optischen Elementen, insbesondere zur Herstellung von holgraphischen Elementen und Bildern.

**13.** Verfahren zur Herstellung einer Photopolymer-Formulierung nach einem der Ansprüche 1 bis 12, bei dem Matrixpolymere, Schreibmonomere, Photoinitiatoren, gegebenenfalls Weichmacher und gegebenenfalls weitere Additive zu der Photopolymer-Formulierung vermischt werden.

**14.** Verfahren zur Belichtung von holographischen Medien aus einer Photopolymer-Formulierung gemäß einem der Ansprüche 1 bis 11, bei dem die Schreibmonomere durch elektromagnetische Strahlung selektiv polymerisiert werden.

## Claims

1. Photopolymer formulation comprising matrix polymers, a combination of at least two different writing monomers and photoinitiators, the matrix polymers being polyurethanes, **characterized in that** the writing monomers differ in their respective refractive indices $n_D^{20}$, measured at a wavelength of 405 nm, by not more than 0.200 and in each case have a refractive index $n_D^{20}$ of ≥ 1.45, measured at a wavelength of 405 nm.

2. Photopolymer formulation according to Claim 1, **characterized in that** the writing monomers differ in their respective refractive indices $n_D^{20}$, measured at a wavelength of 405 nm, by not more than 0.100 and in particular not more than 0.065 and have in each case a refractive index $n_D^{20}$, measured at a wavelength of 405 nm, of ≥ 1.50 and particularly preferably of ≥ 1.55.

3. Photopolymer formulation according to either of Claims 1 and 2, **characterized in that** the writing monomers are acrylates and/or methacrylates, preferably urethane acrylates and/or urethane methacrylates.

4. Photopolymer formulation according to Claim 3, **characterized in that** the writing monomers are mono-, di-, tri- and/or polyfunctional.

5. Photopolymer formulation according to Claim 4, **characterized in that** it contains a combination of a monofunctional and of a polyfunctional, in particular di- or trifunctional, writing monomer or the combination of a di- and a trifunctional writing monomer.

6. Photopolymer formulation according to any of Claims 1 to 5, **characterized in that** the matrix polymers are polyurethanes which are obtainable by reacting an isocyanate component a) with an isocyanate-reactive component b).

7. Photopolymer formulation according to any of Claims 1 to 6, **characterized in that** the photoinitiators are initiators which can be activated by actinic radiation.

8. Photopolymer formulation according to any of Claims 1 to 7, **characterized in that** it contains plasticizers.

9. Photopolymer formulation according to Claim 8, **characterized in that** the plasticizers are urethanes and/or fluorinated urethanes.

10. Photopolymer formulation according to Claim 9, **characterized in that** the urethanes have the general IV

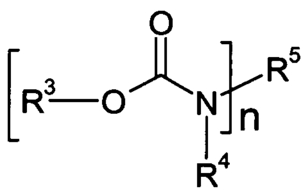

formula IV

in which n is ≥ 1 and n is ≤ 8 and $R^3$, $R^4$, $R^5$ are hydrogen and/or, independently of one another, linear, branched, cyclic or heterocyclic organic radicals which are unsubstituted or optionally also substituted by heteroatoms preferably at least one of the radicals $R^3$, $R^4$, $R^5$ being substituted by at least one fluorine atom and particularly preferably $R^3$ being an organic radical having at least one fluorine atom.

11. Photopolymer formulation according to any of Claims 1 to 10, **characterized in that** it contains 10 to 89.999% by weight, preferably 25 to 70% by weight, of matrix polymers, 10 to 60% by weight, preferably 25 to 50% by weight, of writing monomers, 0.001 to 5% by weight of photoinitiators and optionally 0 to 4% by weight, preferably 0 to 2% by weight, of catalysts, 0 to 5% by weight, preferably 0.001 to 1% by weight, of free radical stabilizers, 0 to 30% by weight, preferably 0 to 25% by weight, of plasticizers and 0 to 5% by weight, preferably 0.1 to 5% by weight, of further additives, the sum of all constituents being 100% by weight.

12. Use of a photopolymer formulation according to any of Claims 1 to 11 for the production of optical elements, in particular for the production of holographic elements and images.

**13.** Process for the preparation of a photopolymer formulation according to any of Claims 1 to 12, in which matrix polymers, writing monomers, photoinitiators, optionally plasticizers and optionally further additives are mixed to give the photopolymer formulation.

**14.** Process for exposing holographic media comprising a photopolymer formulation according to any of Claims 1 to 11, in which the writing monomers are selectively polymerized by electromagnetic radiation.

**Revendications**

**1.** Formulation de photopolymères comprenant des polymères de matrice, une combinaison d'au moins deux monomères d'écriture différents et des photoinitiateurs, les polymères de matrice étant des polyuréthanes, **caractérisée en ce que** les monomères d'écriture ne diffèrent pas de plus de 0,200 au niveau de leur indice de réfraction $n_D^{20}$ respectif mesuré à une longueur d'onde de 405 nm et présentent chacun un indice de réfraction $n_D^{20}$ mesuré à une longueur d'onde de 405 nm $\geq$ 1,45.

**2.** Formulation de photopolymères selon la revendication 1, **caractérisée en ce que** les monomères d'écriture ne diffèrent pas de plus de 0,100, et notamment pas de plus de 0,065, au niveau de leur indice de réfraction $n_D^{20}$ respectif mesuré à une longueur d'onde de 405 nm et présentent chacun un indice de réfraction $n_D^{20}$ mesuré à une longueur d'onde de 405 nm $\geq$ 1,50 et de manière particulièrement préférée $\geq$ 1,55.

**3.** Formulation de photopolymères selon l'une quelconque des revendications 1 ou 2, **caractérisée en ce que** les monomères d'écriture sont des acrylates et/ou des méthacrylates, de préférence des acrylates d'uréthanes et/ou des méthacrylates d'uréthane.

**4.** Formulation de photopolymères selon la revendication 3, **caractérisée en ce que** les monomères d'écriture sont mono-, di-, tri- et/ou multifonctionnels.

**5.** Formulation de photopolymères selon la revendication 4, **caractérisée en ce qu'**elle contient une combinaison d'un monomère d'écriture monofonctionnel et d'un monomère d'écriture multifonctionnel, notamment di- ou trifonctionnel, ou la combinaison d'un monomère d'écriture difonctionnel et d'un monomère d'écriture trifonctionnel.

**6.** Formulation de photopolymères selon l'une quelconque des revendications 1 à 5, **caractérisée en ce que** les polymères de matrice sont des polyuréthanes qui peuvent être obtenus par mise en réaction d'un composant isocyanate a) avec un composant réactif avec les isocyanates b).

**7.** Formulation de photopolymères selon l'une quelconque des revendications 1 à 6, **caractérisée en ce que** les photoinitiateurs sont des initiateurs activables par un rayonnement actinique.

**8.** Formulation de photopolymères selon l'une quelconque des revendications 1 à 7, **caractérisée en ce qu'**elle contient des plastifiants.

**9.** Formulation de photopolymères selon la revendication 8, **caractérisée en ce que** les plastifiants sont des uréthanes et/ou des uréthanes fluorés.

**10.** Formulation de photopolymères selon la revendication 9, **caractérisée en ce que** les uréthanes présentent la formule générale IV

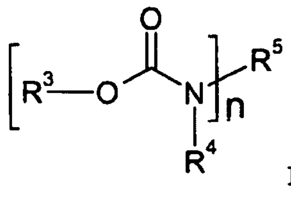

Formule IV

dans laquelle n $\geq$ 1 et n $\leq$ 8, et $R^3$, $R^4$, $R^5$ représentent l'hydrogène et/ou indépendamment les uns des autres des radicaux organiques linéaires, ramifiés, cycliques ou hétérocycliques, non substitués ou éventuellement également

substitués avec des hétéroatomes, au moins un des radicaux $R^3$, $R^4$, $R^5$ étant de préférence substitué avec au moins un atome de fluor et $R^3$ représentant de manière particulièrement préférée un radical organique contenant au moins un atome de fluor.

**11.** Formulation de photopolymères selon l'une quelconque des revendications 1 à 10, **caractérisée en ce qu'**elle contient 10 à 89,999 % en poids, de préférence 25 à 70 % en poids de polymères de matrice, 10 à 60 % en poids, de préférence 25 à 50 % en poids de monomères d'écriture, 0,001 à 5 % en poids de photoinitiateurs et éventuellement 0 à 4 % en poids, de préférence 0 à 2 % en poids de catalyseurs, 0 à 5 % en poids, de préférence 0,001 à 1 % en poids de stabilisateurs de radicaux, 0 à 30 % en poids, de préférence 0 à 25 % en poids de plastifiants et 0 à 5 % en poids, de préférence 0,1 à 5 % en poids d'autres additifs, la somme de tous les constituants étant de 100 % en poids.

**12.** Utilisation d'une formulation de photopolymères selon l'une quelconque des revendications 1 à 11 pour la fabrication d'éléments optiques, notamment pour la fabrication d'éléments et d'images holographiques.

**13.** Procédé de fabrication d'une formulation de photopolymères selon l'une quelconque des revendications 1 à 12, selon lequel des polymères de matrice, des monomères d'écriture, des photoinitiateurs, éventuellement des plastifiants et éventuellement d'autres additifs sont mélangés pour former la formulation de photopolymères.

**14.** Procédé d'éclairage de milieux holographiques constitués par une formulation de photopolymères selon l'une quelconque des revendications 1 à 11, selon lequel les monomères d'écriture sont polymérisés sélectivement par un rayonnement électromagnétique.

Fig. 1

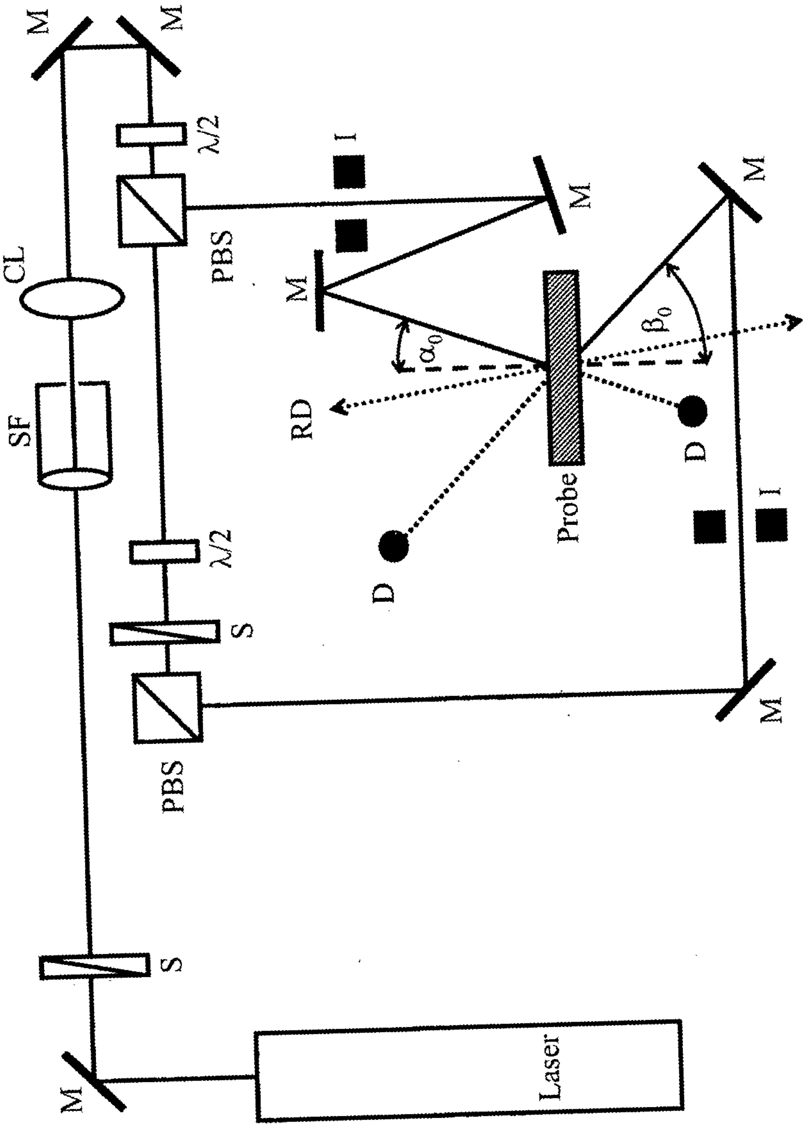
M
M
λ/2
I
PBS
CL
SF
M
M
M
$\alpha_0$
$\beta_0$
RD
D
Probe
D
I
λ/2
S
PBS
M
S
M
Laser

Fig. 2

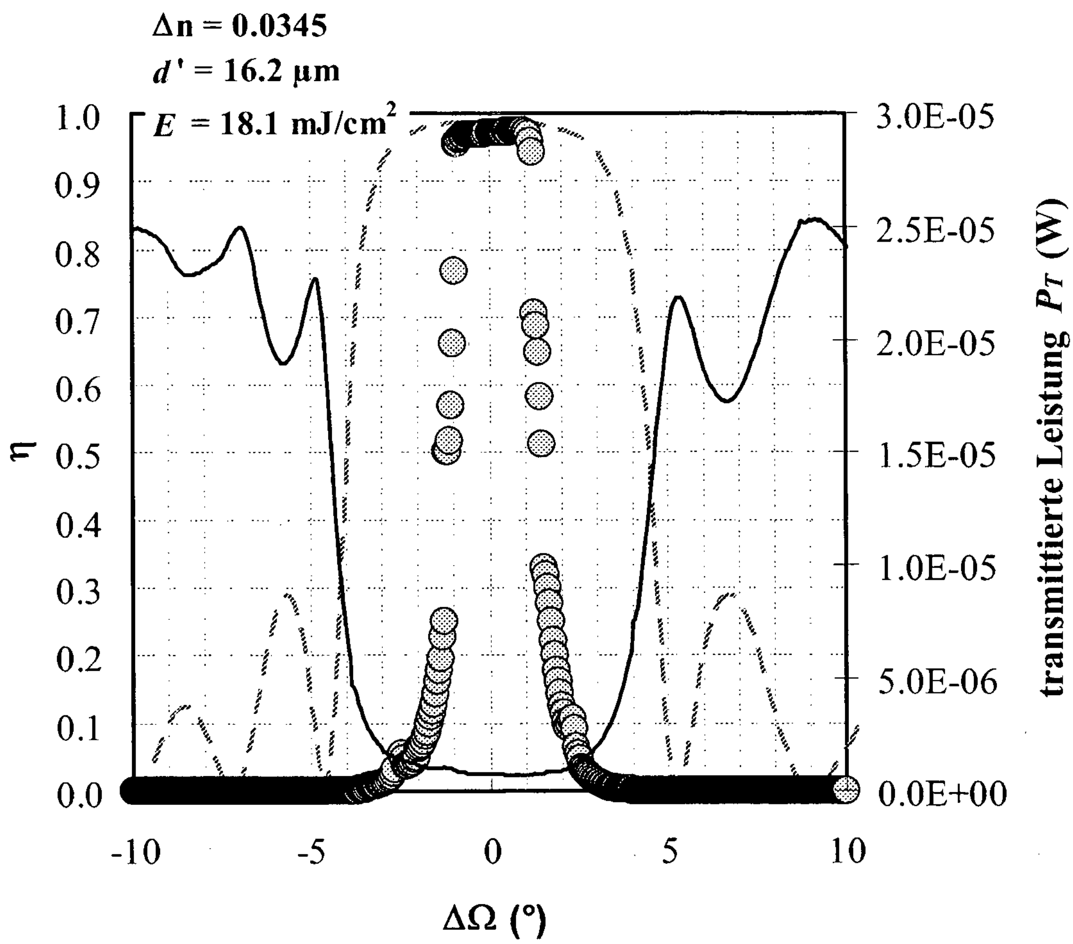
Δn = 0.0345
d' = 16.2 µm
E = 18.1 mJ/cm2
1.0
0.9
0.8
0.7
0.6
0.5
0.4
0.3
0.2
0.1
0.0
η
3.0E-05
2.5E-05
2.0E-05
1.5E-05
1.0E-05
5.0E-06
0.0E+00
transmittierte Leistung PT (W)
-10
-5
0
5
10
ΔΩ (°)

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 2008125229 A1
- WO 2008125229 A
- EP 09009651 A
- EP 09002180 A
- US 5470813 A
- EP 700949 A
- EP 743093 A
- EP 761708 A
- WO 9740086 A
- WO 9816310 A
- WO 0047649 A
- EP 0223587 A


### In der Beschreibung aufgeführte Nicht-Patentliteratur


- **P. HARIHARAN.** Optical Holography. Cambridge University Press, 1996
- **CUNNINGHAM et al.** *RadTech'98 North America UV/EB Conference Proceedings, Chicago,* 19. April 1998
- **KUTAL et al.** *Macromolecules,* 1991, vol. 24, 6872
- **YAMAGUCHI et al.** *Macromolecules,* 2000, vol. 33, 1152
- **NECKERS et al.** *Macromolecules,* 2000, vol. 33, 7761
- **LI et al.** *Polymeric Materials Science and Engineering,* 2001, vol. 84, 139
- **DEKTAR et al.** *J. Org. Chem.,* 1990, vol. 55, 639
- *J. Org. Chem.,* 1991, vol. 56, 1838
- **CRIVELLO et al.** *Macromolecules,* 2000, vol. 33, 825
- **GU et al.** *Am. Chem. Soc. Polymer Preprints,* 2000, vol. 41 (2), 1266
- **HUA et al.** *Macromolecules,* 2001, vol. 34, 2488-2494
- Chemistry & Technology of UV & EB Formulations For Coatings, Inks & Paints. SITA Technology, 1991, vol. 3, 61-328
- **HOUBEN-WEYL.** Methoden der organischen Chemie. Georg Thieme Verlag, 1961, vol. XIV-1, 433ff
- **H. KOGELNIK.** *The Bell System Technical Journal,* November 1969, vol. 48 (9), 2909, 2947